**Europäisches Patentamt**

**European Patent Office**

**Office européen des brevets**

(19)

(11) Veröffentlichungsnummer: **0 165 489**

**A1**

(12) # EUROPÄISCHE PATENTANMELDUNG

(21) Anmeldenummer: 85106164.8

(51) Int. Cl.⁴: **G 01 R 15/07**

(22) Anmeldetag: 20.05.85

(30) Priorität: 24.05.84 DE 3419429
13.02.85 DE 3504945

(43) Veröffentlichungstag der Anmeldung:
27.12.85 Patentblatt 85/52

(84) Benannte Vertragsstaaten:
AT CH DE FR GB LI NL SE

(71) Anmelder: MITEC Moderne Industrietechnik GmbH
Daimlerstrasse 15
D-8012 Ottobrunn(DE)

(72) Erfinder: Mehnert, Walter, Dr. Dipl.-Ing.
Grillparzerstrasse 6
D-8012 Ottobrunn(DE)

(74) Vertreter: Strasser, Wolfgang, Dipl.-Phys et al,
Patentanwälte Strohschänk, Uri & Strasser Innere
Wiener Strasse 8
D-8000 München 80(DE)

(54) Anordnung zum Messen der elektrischen Spannungsparameter eines Hochspannungsleiters.

(57) Zur Messung der Spannungsparameter, wie Momentan-wert, Phasenlage, Absolutwert oder Vorzeichen der Hoch-spannung eines Hochspannungsleiters (1) ist ein Sensor (15) mit einer nichtgeerdeten, in der Nähe des Hochspannungs-leiters (1) längs einer Äquipotentialfläche angeordneten Elektrode (10) und einer Referenzelektrode leitend verbun-den, die beide auf einem definierten Potential liegen. Die Referenzelektrode kann der Hochspannungsleiter (1), eine zweite längs einer Äquipotentialfläche angeordnete Elektro-de (50) oder ein mit dem Hochspannungsleiter (1) leitend verbundener Hilfsleiter (57) sein. Der Sensor, der ein einsei-tig eingespannter mechanischer Piezoschwinger sein kann, moduliert die Helligkeit eines eingestrahlten Lichtbündels (32), das zum Meßgerät reflektier, von einem Empfänger (40) in ein elektrisches Signal umgewandelt und ausgewertet wird. Zur Überprüfung der Funktionsfähigkeit kann dem Sensor (15) ein von der Energie des Hochspannungsleiters unabhängiges Anregungssignal zur kurzzeitigen Modulation des eingestrahlten Lichtbündels übermittelt werden. Zur Erkennung der Null-Lage beim Anliegen einer Gleichspan-nung am Hochspannungsleiter kann der Sensor vermittels einer auf Funktionsfähigkeit überprüfbaren Schaltungsa-nordnung spannungsfrei geschaltet oder umgepolt werden.

./...

FIG. 1

Anordnung zum Messen der elektrischen Spannungsparameter eines Hochspannungsleiters

Die Erfindung betrifft eine Anordnung zum Messen der elektrischen Spannungsparameter eines Hochspannungsleiters
gemäß dem Oberbegriff von Anspruch 1.

Mit dem Begriff "Hochspannung" sollen im vorliegenden
Zusammenhang Gleich- und Wechselspannungen verstanden
werden, die in einem Bereich von 1 kV bis 800 kV und mehr
liegen. Der Ausdruck "Spannungsparameter" besagt, daß
bei Gleichspannungen nicht nur deren Absolutwert sondern
auch das Vorzeichen und bei Wechselspannungen nicht nur
der Scheitel- bzw. Effektivwert sondern auch der zeitliche Spannungsverlauf meßbar sind, so daß die relative
Phasenlage mehrerer solcher Spannungen festgestellt und
zahlenmäßig angegeben werden kann.

Eingesetzt werden Anordnungen der eingangs genannten Art
beispielsweise immer dann, wenn vor dem Beginn von Arbeiten an einem Hochspannungsleiter oder in seiner unmittelbaren Nähe sichergestellt werden muß, daß der Leiter spannungsfrei ist bzw. zur Ableitung von eingekoppelten Blindspannungen gefahrlos geerdet werden kann.

Zur Erfassung der Wechselspannung und/oder des Wechselstroms in Überlandleitungen ist aus der US-PS 4,002,975
eine Anordnung der im Oberbegriff des Anspruches 1 beschriebenen Art bekannt, die einen Meßkopf umfaßt, der
am oberen Ende einer aus isolierendem Material bestehenden Tragsäule angeordnet und über diese Säule mit dem
Meßgerät fest verbunden ist. Zur Messung der Spannung wird das Meßgerät neben einem Masten der Überlandleitung auf dem Erdboden so aufgestellt, daß sich der Meßkopf in der Nähe des Hochspannungsleiters befindet, ohne diesen jedoch zu berühren. Im Meßkopf ist ein Sensor angeordnet, auf den im Inneren der Tragsäule vom Meßgerät her ein Lichtbündel projiziert wird, das den Sensor durchsetzt und über einen hinter dem Sensor angeordneten Spiegel wieder zum Meßgerät zurückreflektiert wird. Der Sensor beeinfluß im vorliegenden Fall das Lichtbündel in der Weise, daß er die Polarisationsebene des linear polarisierten Lichtes in Abhängigkeit von der Intensität des umgebenden elektrischen oder magnetischen Feldes dreht. Die Polarisationsänderung des reflektierten Lichtbündels wird gemessen, um die Intensität des den Hochspannungsleiter umgebenden Feldes anzuzeigen. Da der Polarisations-Modulationskoeffizient derartiger Kristalle in sehr starkem Maß von der Umgebungstemperatur abhängt, enthält der Meßkopf weiterhin eine ebenfalls über ein Lichtbündel abfragbare Temperaturmeßvorrichtung, die entweder ein Korrektursignal liefert oder dazu dient, den Meßkopf über die Tragsäule zu heizen und somit auf einer vorgebebenen Temperatur zu halten.

Diese bekannte Anordnung ist einerseits unhandlich, weil die Tragsäule, die das Meßgerät mit dem Meßkopf verbindet, eine beträchtliche Länge aufweisen muß, damit der Sensor bei Überlandleitungen genügend nahe an die spannungsführenden Leiter herangebracht werden kann. Zum anderen wird die Genauigkeit der Messung in erheblichem Maße vom Abstand beeinflußt, den der Meßkopf und damit der Sensor vom Hochspannungsleiter besitzt. Da der Abstand der Leiter von Überlandleitungen zum Boden nur in unmittelbarer Nähe der Tragmasten genau definiert ist, muß dieses bekannte Meßgerät auch neben diesen Tragmasten aufgestellt werden. Dort wird jedoch das den Hochspannungsleiter umgebende Feld durch die in der Nähe befindlichen geerdeten Teile des Mastes in starkem Maße verzerrt, so daß
selbst dann, wenn der Abstand des Sensors vom Hochspannungsleiter mit großer Genauigkeit bekannt ist (was
in der Praxis jedoch normalerweise nicht der Fall ist)
eine genaue Messung nicht möglich ist.

Eine solche geringe Meßgenauigkeit stellt aber ein erhebliches Gefahrenmoment dar, weil sie es nicht erlaubt,
mit absoluter Sicherheit die oben bereits erwähnten Blindspannungen von der Hochspannung zu unterscheiden, die am
Hochspannungsleiter anliegt, wenn dieser mit der Leistungsquelle verbunden ist.

Das Ausmaß, in dem die verwendeten Sensoren die Polarisation des eingestrahlten Lichtbündels verändern können,
ist auch bei Anliegen der vollen Nenn-Hochspannung sehr gering, so daß nur ein sehr kleines Meßsignal entsteht. Darüber hinaus wird durch diese Sensoren und die zugehörigen
Polarisationsfilter das Meßlicht sehr stark gedämpft, wodurch bei größeren Meßstrecken nur ein sehr schwaches und
wegen seines ungünstigen Signal/Rausch-Verhältnisses schlecht
auszuwertendes Reflexionslichtbündel zum eigentlichen Meßgerät zurückkommt. Aus diesem Grund und wegen der dann erforderlichen, sehr langen Tragsäule für den Meßkopf ist die
bekannte Vorrichtung für eine Messung über größere Strecken,
z.B. an Freileitungen mit einer Höhe von 100 m oder mehr
über dem Boden nicht geeignet.

Völlig ungeeignet ist die bekannte Vorrichtung auch für einen
weiteren wichtigen Anwendungsfall, bei dem die Spannungsfreiheit der im Inneren eines mit $SF_6$ gefüllten Schaltschrankes befindlichen Hochspannungsleiter festgestellt
werden muß. Ein solcher Schaltschrank darf nur geöffnet
werden, wenn keine Hochspannung anliegt, weil durch das Eindringen von Luft die Schutzwirkung des $SF_6$ vermindert bzw. völlig aufgehoben wird und es zu äußerst gefährlichen und zerstörerischen Spannungsüberschlägen kommen würde, wenn der Schaltschrank bei anliegender Hochspannung geöffnet würde.

Demgegenüber liegt der Erfindung die Aufgabe zugrunde, eine Anordnung der eingangs genannten Art zu schaffen, die einen einfachen und kompakten Aufbau besitzt und eine gefahrlose Hochspannungsmessung mit großer Genauigkeit ermöglicht.

Zur Lösung dieser Aufgabe sieht die Erfindung die im Anspruch 1 niedergelegten Merkmale vor.

Durch die erfindungsgemäßen Maßnahmen wird erreicht, daß die vom Sensor erfaßte und in eine Beeinflussung des eingestrahlten Lichtbündels umgesetzte Potentialdifferenz exakt definiert ist, weil sie nur noch von der festen gegenseitigen Anordnung von Teilen der Sensoreinheit abhängt, die ihrerseits zumindest während der Messung durch die unmittelbare Berührung des Hochspannungsleiters gegenüber diesem eine genau definierte und reproduzierbare Lage einnimmt.

Vorzugsweise ist das von der Bedienungsperson zu handhabende Meßgerät gegen die Sensoreinheit frei beweglich. D.h., das Meßgerät ist entweder von der Sensoreinheit körperlich immer vollständig getrennt, wobei das Meßlicht durch eine von einer Fernrohranordnung gebildete Projektionsvorrichtung übertragen wird, oder es ist lediglich während des Meßvorganges über eine einen Teil der Projektionsvorrichtung bildende Lichtleiteranordnung mit der Sensoreinheit verbunden, wobei diese Lichtleiteranordnung vorzugsweise aus zwei Lichtleitfasern besteht, von denen die eine an der Sensoreinheit montiert ist und eine
solche Länge besitzt, daß ihr freies Ende gefahrlos zugänglich ist. Mit diesem freien Ende kann dann eine weitere zum Meßgerät gehörende Lichtleitfaser z.B. durch
einen Steckverbinder für die Dauer der Messung optisch
gekoppelt werden.

Die erste Ausführungsform ist vor allem für eine Verwendung an Überlandleitungen gedacht, wobei an einer Vielzahl von Hochspannungsleitern jeweils eine Sensoreinheit
dauerhaft montiert sein kann. Alle diese Sensoreinheiten
können mit Hilfe eines einzigen Meßgerätes jeweils zur
Durchführung eines Meßvorganges vom Boden aus angepeilt
werden. Alternativ kann die Sensoreinheit auch so ausgebildet sein, daß sie nur für die Dauer des Meßvorganges
auf den Hochspannungsleiter aufgesteckt und dann wieder
abgenommen wird.

Die zweite Ausführungsform ist besonders für Schaltschränke geeignet, die mit $SF_6$ gefüllt sind. Die Sensoreinheit
wird hier im Inneren des Schaltschranks dauerhaft am Hochspannungsleiter montiert. Das vom Sensor abgewandte Ende
der zugehörigen Lichtleitfaser ist mit dem einen Teil eines optischen Verbinders verbunden, das gasdicht so in
eine Außenwand des Schaltschrankes eingebaut ist, daß das
andere Teil des opitischen Verbinders, in welchem die
zum Meßgerät gehörende Lichtleitfaser endet, von außen
her gefahrlos angesteckt werden kann.

Als Referenzelektrode kann in jedem Fall entweder der Hochspannungsleiter selbst oder eine zweite Elektrode dienen,
die in entsprechender Weise wie die erste Elektrode zum
Hochspannungsleiter in einem definierten Abstand angeordnet ist, der sich vom Abstand der ersten Elektrode zum Hochspannungsleiter so unterscheidet, daß zwischen den beiden Elektroden die für den Betrieb des Sensors erforderliche Spannung abfällt.

Eine weitere Möglichkeit besteht darin, als Referenzelektrode einen Hilfsleiter vorzusehen, der mit dem Hochspannungsleiter elektrisch leitend so verbunden ist, daß eine möglichst geringe Verzerrung des Potentialfeldes eintritt. Dieser Hilfsleiter trägt dann seinerseits die erste (und gegebenenfalls die zweite) Elektrode sowie die übrigen Teile der Sensoreinheit, wobei insbesondere die Elektrode(n) wieder eine genau definierte Lage im Potentialfeld einnehmen.

Bei einer dritten Ausführungsform sind das Meßgerät und die Sensoreinheit durch eine isolierende Stange miteinander verbunden, die eine solche Länge besitzt, daß sie von der Bedienungsperson an dem einen Ende angefaßt und mit dem anderen Ende, aus dem ein Hilfsleiter vorsteht, gefahrlos mit dem Hochspannungsleiter in direkte galvanisch leitende Berührung gebracht werden kann. Diese Ausführungsform ist für niedrig über dem Boden verlaufende Hochspannungsleitungen sowie für die Fälle geeignet, in denen die Bedienungsperson einen Tragmasten einer Überlandleitung erklettern und von dort aus die Spannungsfreiheit des Hochspannungsleiters feststellen muß. Da die Stange nur die für einen Spannungsschutz unbedingt erforderliche Länge besitzt, kann sie hierbei mitgenommen werden. Überdies kann sie teleskopartig zusammenschiebbar ausgebildet sein. Vorzugsweise ist die Sensoreinheit im Inneren der hohl ausgebildeten Stange in der Nähe des oberen Endes der Stange untergebracht, während das Meßgerät sich in der Nähe des anderen, von der Bedienungsperson zu ergreifenden Endes befindet. Die Verbindung zwischen Meßgerät und Sensoreinheit kann beispielsweise durch eine im Inneren der Stange verlaufende Lichtleitfaser hergestellt sein.

Bei jeder dieser Ausgestaltungen arbeitet die erfindungsgemäße Vorrichtung als kapazitiver Spannungsteiler, bei
dem die Kapazität des Sensors zwischen dem Hochspannungsleiter bzw. dem Hilfsleiter bzw. der zweiten
Elektrode und der ersten Elektrode und die Kapazität
der ersten Elektrode gegen Erde miteinander in Reihe
liegen. Es stehen Sensoren zur Verfügung, mit denen sich
ohne weiteres eine Kapazität kleiner 100 pF erreichen
läßt. Durch eine geeignete Größe der ersten Elektrode und
eine geeignete Wahl ihres Abstandes von der Referenzelektrode ist eine Elektrodenkapazität gegen Erde von
einigen Picofarad erzielbar. Bei den zu messenden hohen
Spannungen ist das den Hochspannungsleiter umgebende
Feld ohne weiteres stark genug, um bei einem solchen
Teilungsverhältnis den Sensor ausreichend mit Energie
zu versorgen.

Das bisher beschriebene erfindungsgemäße Prinzip ist
nicht auf die Verwendung eines ganz bestimmten Sensortyps beschränkt. Grundsätzlich kann jeder auf die Feldstärkenänderungen in der Umgebung des Hochspannungsleiters oder des Hilfsleiters reagierende Sensor verwendet
werden, der eine genügend kleine Kapazität besitzt. Geeignet sind unter anderem PLZT- bzw. PLMZT-Plättchen,
die durch sie hindurchgehendes Licht in Abhängigkeit von
der angelegten Spannung unterschiedlich stark streuen,
so daß durch eine im Lichtweg nachfolgende Blende unterschiedlich große Lichtmengen hindurchtreten und hierdurch
die Helligkeit des zum Meßgerät zurückgeführten Lichtbündels moduliert wird.

Auch die Polarisationseigenschaften des eingestrahlten
Lichtbündels ändernde Sensoren können prinzipiell Verwendung finden.

Besonders bevorzugt ist jedoch ein mechanischer Schwinger,
beispielsweise ein aus piezoelektrischem Material bestehendes Stäbchen, das in der Nähe seines einen Endes mechanisch
eingespannt ist und dessen freies Ende in Abhängigkeit
von der umgebenden Feldstärke aus der Ruhelage ausgelenkt
wird. Führt der Hochspannungsleiter, an dem eine Sensoreinheit mit einem solchen mechanischen Schwinger befestigt
ist oder über einen Hilfsleiter in elektrisch leitende
Berührung kommt, Wechselspannung, so führt dies zu einer
periodischen Biegeschwingung des Piezokristalls, deren
Frequenz gleich der der Wechselspannung und deren Amplitude proportional zur Amplitude der Feldstärke und damit
zur Hochspannung ist. Diese Schwingung wird erfindungsgemäß dazu verwendet, um ein vom Meßgerät her eingestrahltes und zum Meßgerät reflektiertes Lichtbündel in seiner
Helligkeit zu modulieren, so daß mit Hilfe eines Photoempfängers aus dem modulierten Licht ein elektrisches
Wechselsignal gewonnen werden kann, dessen Amplitude
proportional zur Hochspannung ist, das die Phasenlage
der Hochspannung wiedergibt und das entsprechend ausgewertet und angezeigt werden kann.

Führt der Hochspannungsleiter, an dem eine Sensoreinheit mit einem solchen mechanischen Schwinger befestigt
ist, dagegen eine Gleichspannung, so wird der mechanische
Schwinger nur einseitig und permanent aus seiner Ruhelage
ausgelenkt. Auch diese Auslenkung kann dazu verwendet werden, die Helligkeit eines eingestrahlten Lichtbündels
proportional zur Auslenkung zu verändern, so daß aus
dem zurückgeführten Lichtbündel ein Meßwert und eine
Anzeige für die Größe und das Vorzeichen der anliegenden Hochspannung gewonnen werden kann.

Zur Erzielung der Helligkeitsmodulation trägt vorzugsweise der in der Nähe seines einen Endes eingespannte
mechanische Schwinger an der Stirnfläche seines freien
Endes eine vorzugsweise aufgedampfte Spiegelschicht, die
von dem von der Projektionsvorrichtung eingestrahlten
Lichtbündel getroffen wird und hiervon einen Teil, dessen
Größe von der zu messenden Hochspannung abhängt, in die
Projektionsvorrichtung reflektiert, von der dieser Teil zum Meßgerät zurückgeführt wird. Aufgrund der durch die Hochspannung bewirkten periodischen oder permanenten Auslenkung
des freien Endes des mechanischen Schwingers aus seiner
Ruhelage wird die Spiegelschicht gegen die optische Achse
der Projektionsvorrichtung seitlich versetzt und gleichzeitig winkelmäßig verkippt. Beides trägt dazu bei, daß
sich die Lichtmenge, die zum Meßgerät zurückgeführt wird,
in Abhängigkeit von der Auslenkung ändert, wobei durch
geeignete Wahl der Spiegelform, der Neigung des Spiegels
gegen die optische Achse in der Ruhelage des Schwingers
und der Größe und Form der Eintrittsblende (Loch- oder
Schlitzblende bzw. Stirnfläche einer Lichtleitfaser)
ein weitgehend linearer Zusammenhang erzielbar ist,
und erreicht wird, daß das beim Maximalausschlag reflektierte Licht maximale Helligkeit besitzt.

Ein derartiger mechanischer Schwinger als Sensor bietet
darüber hinaus die Vorteile, daß er einerseits das eingestrahlte Licht nur in sehr geringem Maß dämpft und andererseits einen sehr hohen Modulationsgrad ermöglicht. Somit erzielt man ein sehr gutes Signal/Rauschverhältnis
und maximale Helligkeit für das am Photoempfänger erhaltene Licht. Dadurch sind Messungen auch über große
Abstände mit hoher Genauigkeit möglich.

0165489

Es sei ausdrücklich darauf hingewiesen, daß Lichtquelle und Lichtempfänger nicht notwendigerweise in ein und demselben Gehäuse untergebracht und an derselben Stelle aufgestellt sein müssen. Wegen der sich hieraus ergebenden besseren Handlichkeit ist es jedoch bevorzugt, diese Teile der Anordnung zu einem kompakten Meßgerät zusammenzufassen.

In all den Fällen, in denen die Sensoreinheit fest am Hochspannungsleiter montiert ist, ist sie für eine Überprüfung ihrer Funktionsfähigkeit nicht ohne weiteres zugänglich. Da aber eine vom Meßgerät gelieferte Anzeige, daß keine Hochspannung am Hochspannungsleiter anliegt, nur dann zuverlässig ist, wenn gleichzeitig feststeht, daß die Sensoreinheit einwandfrei arbeitet, besteht ein besonders wichtiger Gesichtspunkt der Erfindung darin, daß der Sensor durch ein von der im Hochspannungsleiter übertragenen Energie unabhängiges Anregungssignal zu einer Veränderung des eingestrahlten Lichtbündels anregbar ist. Dies kann in der Form geschehen, daß in der Sensoreinheit eine beispielsweise durch eine Photozelle aufladbare Kondensatorbatterie angeordnet ist, deren Energie aufgrund eines Anregungssignales, das auf optischem oder akustischem Weg oder per Funk eingestrahlt werden kann, über den Sensor entladen wird und dabei den Sensor veranlaßt, zum Beispiel die Helligkeit oder die Polarisation des eingestrahlten Lichtbündels kurzzeitig zu verändern. Wird eine derartige Veränderung dann am Meßgerät erfaßt und angezeigt, so kann davon ausgegangen werden, daß die Sensoreinheit einwandfrei arbeitet und das Fehlen eines Meßsignals darauf zurückzuführen ist, daß am Hochspannungsleiter tatsächlich keine Hochspannung anliegt.

Um ein besonders gut auswertbares Überprüfungssignal zu
erhalten, wird vorzugsweise der Sensor als Teil eines
Schwingsystems ausgebildet, das eine genau definierte
Resonanzfrequenz besitzt, die von der Frequenz des zu
messenden Wechselfeldes deutlich verschieden ist und
für eine Wechsel-Hochspannung von 50 Hz oder 60 Hz z.B.
1,5 kHz beträgt. Weiterhin umfaßt das Schwingsystem einen
Empfänger für das Anregungssignal, der vorzugsweise
als Photodiode ausgebildet ist, die vom Meßgerät her mit
Licht angestrahlt werden kann, das in diesem Fall mit
einer Frequenz helligkeitsmoduliert ist, die gleich der
Resonanzfrequenz des Schwingsystems ist oder dieser möglichst nahekommt. Da zum Anstoß der Resonanzschwingung
nur eine sehr geringe Energie erforderlich ist, genügt die
von der rein photovoltaisch arbeitenden Photodiode aufgrund des eingestrahlten Lichtes abgegebene Spannung,
um in der geschilderten Weise die Funktionsfähigkeit
der Sensoreinheit zu überprüfen.

Wird ein Sensor verwendet, der die Helligkeit des eingestrahlten Lichtes in Abhängigkeit von dem umgebenden
Wechselfeld moduliert, so dient die Amplitude des vom
photoelektrischen Empfänger abgegebenen Signals als
Maß für die Größe der am Hochspannungsleiter anliegenden
Spannung. Ist die Sensoreinheit im Freien angeordnet und
erfolgt die Meßlichtübertragung zwischen Meßgerät und
Sensoreinheit mit Hilfe einer Fernrohranordnung, so wird
die Größe der Amplitude des Ausgangssignals des Photoempfängers bei gegebener Helligkeit des vom Meßgerät abgestrahlten Lichtes nicht nur von der Größe der zu messenden Hochspannung sondern auch von einer Reihe von Störfaktoren beeinflußt, von denen die wichtigsten die Temperatur

0165489

des Sensors und die Transparenz der zwischen Meßgerät und Sensoreinheit befindlichen Luft sind. Auch das Verschmutzen, Beschlagen mit Wasserdampf oder Vereisen von Teilen der Projektionsvorrichtung spielen hier eine Rolle, doch lassen sich gegen diese zuletztgenannten Störeffekte von vornherein wirksame Gegenmaßnahmen wie Kapselung, schmutzabweisende Oberflächenbehandlung von Linsen und Spiegeln und ähnliches ergreifen.

Konstruktiv nicht immer beeinflußbar sind jedoch die Temperatur- und Transparenzabhängigkeit, so daß hier erfindungsgemäß Kompensationsmaßnahmen ergriffen werden.

Zur Eliminierung der Temperaturabhängigkeit des Sensors dient das bereits erwähnte Anregungssignal, mit dessen Hilfe der Sensor zu einer von der im Hochspannungsleiter übertragenen Energie unabhängigen Beeinflussung des eingestrahlten Lichtes angestoßen werden kann. Sowohl aus der Amplitude, mit der der Sensor auf das Anregungssignal reagiert, als auch aus dem Dämpfungsverlauf der nach Beendigung des Anregungssignals abklingenden Schwingung des Sensors lassen sich Korrekturwerte zur Eliminierung der Temperaturabhängigkeit des Schwingungsverhaltens des Sensors sowie zur Beseitigung der übrigen Umwelteinflüsse gewinnen. Beispielsweise ist es möglich, aus der Amplitude der durch das Hochspannungsfeld erzwungenen Schwingung des Sensors und aus der Amplitude der durch das Anregungssignal verursachten Resonanzschwingung das Verhältnis zu bilden, um eine Temperaturkompensation zu erzielen. Eine andere Möglichkeit besteht darin, aus der Amplitude und dem Dämpfungsverhalten der vom Anregungssignal angestoßenen Resonanzschwingung in Abhängigkeit von der Temperatur Eichwerte zu ermitteln, die dann bei der jeweiligen Messung zur Korrektur des interessierenden Hochspannungsmeßwertes herangezogen werden können.

0165489

Zur Berücksichtigung des Einflusses der Lufttransparenz und eventueller Änderungen der Transparenz bzw. des Reflexionsvermögens von Linsen, Spiegeln und anderen optischen Elementen der Projektionseinrichtung durch Beschlagen, Verschmutzen oder Alterung kann/dann, wenn eine Wechsel-Hochspannung gemessen werden soll, in unmittelbarer Nähe des Sensors ein feststehender Spiegel vorgesehen sein, der im wesentlichen auf demselben optischen Weg, auf dem das Meßlicht zum Sensor gelangt, einen vorgegebenen Teil des Meßlichtes erhält und diesen vom Sensor nicht beeinflußten Gleichlichtanteil im wesentlichen auf demselben Weg zum Meßgerät reflektiert, auf dem auch das vom Sensor modulierte Meßlicht zurück übertragen wird. Mit Ausnahme der Beeinflussung durch den Sensor selbst ist somit dieser Gleichlichtanteil denselben Umwelteinflüssen unterworfen wie das Meßlicht und kann dazu verwendet werden, die Messung von der absoluten Helligkeit des empfangenen Meßlichtes unabhängig zu machen. Zu diesem Zweck kann der Gleichlichtanteil mit Hilfe von Umschalteinrichtungen oder Strahlenteilern optisch oder nach Empfang durch ein und denselben photoelektrischen Empfänger auf elektrischem Wege vom Meßlichtanteil getrennt werden. Bei der Messung einer Gleichhochspannung muß der feststehende Spiegel jedoch weggelassen werden, wenn der von ihm erzeugte Gleichlichtanteil vom Gleichlichtanteil der Hochspannung nicht getrennt werden kann.

Zur Durchführung einer Bestimmung der relativen Phasenlage der Wechselspannungen von zwei oder mehr Hochspannungsleitern wird erfindungsgemäß auf jedem der Hochspannungsleiter eine Sensoreinheit angebracht und das reflektierte Licht jeweils auf einen eigenen elektro-optischen Empfänger geführt. Diese Empfänger können alle in ein und demselben Meßgerät untergebracht sein oder es kann eine entsprechende Anzahl von Meßgeräten, von denen jedes einen eigenen Empfänger besitzt, miteinander gekoppelt werden.

Wie bereits erwähnt, ist die erfindungsgemäße Anordnung
auch zum Messen von Gleich-Hochspannungen geeignet. Dies
ist nicht nur dann von Bedeutung, wenn der zu prüfende
Hochspannungsleiter ohnehin immer Gleichspannung führt.
Auch bei Wechsel-Hochspannungsleitern, vor allem bei
Frei- und Überlandleitungen kann bei abgeschalteter
Wechselspannung in den Hochspannungsleiter z.B. von einer
über der Leitung stehenden, elektrisch geladenen Gewitterwolke ein sehr hohes Gleichspannungspotential induziert
werden, das ein gefahrloses Berühren oder Erden des Leiters unmöglich macht.

Um die Größe derartiger Gleichspannungen messen zu können,
ist es erforderlich, den Nullpunkt der Anordnung zu
kennen, da der Sensor in diesem Fall das eingestrahlte
Licht nicht periodisch verändert, also beispielsweise
nicht periodisch schwingt, sondern in einer dem Vorzeichen der Gleichspannung entsprechenden Richtung
konstant aus seiner Ruhelage ausgelenkt ist. Vor allem
bei fest am Hochspannungsleiter montierten Sensoreinheiten ist die Bestimmung des Meß-Nullpunkts nicht ohne
weiteres möglich, da die Helligkeit des vom Meßgerät
empfangenen, vom Sensor reflektierten Lichtes durch
eine Vielzahl von Faktoren beeinflußt wird und ein Vergleich mit der Helligkeit des vom Meßgerät ausgesandten
Lichts nicht zu brauchbaren Ergebnissen führt.

Zur Lösung dieses Problems ist gemäß einer besonders
bevorzugten Ausführungsform der Erfindung vorgesehen,
daß die Sensoreinheit eine Nullpunkts-Schaltungsanordnung
umfaßt, mit deren Hilfe der Sensor dazu veranlaßt werden
kann, Signale abzugeben, aus denen sich seine Nullpunktslage ableiten läßt, die dem spannungsfreien Zustand des Hochspannungsleiters entspricht. Vorzugsweise besteht diese Nullpunkts-Schaltungsanordnung aus einem oder mehreren steuerbaren Schaltern, mit deren Hilfe die am Sensor abfallende Spannung verändert, beispielsweise kurzgeschlossen oder umgepolt werden kann, so daß der Sensor auch beim Anliegen einer Gleichspannung entweder zwangsweise in seine Null- oder Ruhelage gebracht oder zu einem gleichgroßen Ausschlag in der entgegengesetzten Richtung veranlaßt werden kann. Im ersten Fall dient dann die Helligkeit des in der Ruhelage des Sensors zum Meßgerät reflektierten Lichtbündels als Nullwert, während im zweiten Fall der Mittelwert zwischen den beiden Helligkeitswerten vor und nach dem Umpolen als Nullwert verwendet werden kann. Auch kann die galvanische Verbindung des Sensors mit dem Hochspannungsleiter und/oder der sich längs einer Äquipotentialfläche erstreckenden Elektrode durch einen steuerbaren Schalter unterbrochen werden, um so den Sensor zwangsweise spannungsfrei zu machen und zum Übergang in die Ruhelage zu veranlassen.

Die Betätigung der steuerbaren Schalter erfolgt mit Hilfe einer in der Sensoreinheit untergebrachten Steuerschaltung, die ihre Energie z.B. aus der Spannung bezieht, die zwischen dem Hochspannungsleiter bzw. der Referenzelektrode und der sich längs einer Äquipotentialfläche erstreckenden Elektrode abfällt. Beispielsweise besteht die Steuerschaltung im wesentlichen aus einem Monoflop, das aufgrund eines eingestrahlten Befehlssignals den oder die Schalter für eine festgelegte Zeit aus dem Ruhezustand in den Arbeitszustand und dann wieder zurück in den Ruhezustand schaltet. Dabei ist zu beachten, daß im Arbeitszustand der Schalter der Sensor in seine Ruhelage gebracht bzw. umgepolt wird.

Vorzugsweise wird das Befehlssignal für die Steuerschaltung mit Hilfe des vom Meßgerät ausgesandten Lichtbündels eingestrahlt, wobei es von einer Fotodiode empfangen und in ein elektrisches Steuersignal für die steuerbaren Schalter umgesetzt wird.

In den Fällen, in denen der Sensor Teil eines Resonanzschwingsystems ist, das zur Überprüfung der Funktionstüchtigkeit des Sensors mit Hilfe eines Anregungssignals auch dann zu Schwingungen angeregt werden kann, wenn am Hochspannungsleiter keine Spannung anliegt, kann ein Teil dieses Anregungssignals als Befehlssignal für die Steuerschaltung verwendet werden. So kann z.B. ein Monoflop mit Hilfe der ersten steigenden Flanke des Anregungssignals getriggert werden. Schaltet man zwischen den jeweiligen Ausgang des Monoflops und den oder die von diesem Ausgang angesteuerten Schalter ein Verzögerungsglied mit einer geeigneten Verzögerungszeit, so kann man bei entsprechender Ausbildung des Anregungssignals aus dem vom Sensor reflektierten Lichtbündels nicht nur Informationen über den Meß-Nullpunkt und die Größe der am Hochspannungsleiter anliegenden Gleichspannung, sondern auch über die Funktionstüchtigkeit des Sensors und die Funktionstüchtigkeit der Nullpunkts-Schaltungsanordnung ableiten.

Eine andere Möglichkeit besteht darin, neben der Photodiode, die zum Anregen des Resonanzschwingsystems dient, eine zweite Photodiode vorzusehen, der vom Meßgerät her ein eigenes Lichtbündel zugeführt wird, das vom eigentlichen Meßlichtbündel, das auch zur Übertragung des Anregungssignals für das Resonanzschwingsystem dient, völlig unabhängig ist.

Mit Hilfe dieser zweiten Photodiode, die ebenfalls
rein photovoltaisch arbeitet, wird vorzugsweise
durch Einstrahlen eines Gleichlichtsignals über einen
Widerstand ein Kondensator aufgeladen, wobei der
Spannungsabfall, der durch den Ladestrom am Widerstand verursacht wird, als Steuersignal zum Betätigen der steuerbaren Schalter dient. Dieses Steuersignal
liegt unabhängig von der Dauer des Gleichlichtsignals
nur solange an den Schaltern an, bis der Kondensator
völlig aufgeladen ist. Dadurch besteht die Möglichkeit,
nicht nur das Vorhandensein einer Gleichspannung zwischen dem Hochspannungsleiter und dem Sensor festzustellen, sondern in Verbindung mit dem Resonanzschwingsystem neben der Funktionsfähigkeit des Sensors selbst
auch die der Nullpunkts-Schaltungsanordnung zu überprüfen. In Verbindung mit Halbleiterschaltern zeichnet
sich diese Nullpunkts-Schaltungsanordnung durch einen
besonders geringen Energiebedarf aus, der ohne weiteres
durch das eingestrahlte Gleichlichtsignal gedeckt werden kann.


Die Erfindung wird im folgenden anhand von Ausführungsbeispielen unter Bezugnahme auf die Zeichnung beschrieben; in dieserzeigt:

Fig. 1            eine stark schematisierte, geschnittene
                  Seitenansicht einer ersten, fest am Hochspannungsleiter montierten Ausführungsform,

Fig. 2            einen Schnitt längs der Linie II-II aus
                  Fig. 1,

| Fig. 3 | in schematischer Form die relative Lage von Sensor und Blende gemäß einer ersten Variante, |
|---|---|
| Fig. 4 | eine der Fig. 3 entsprechende Ansicht gemäß einer zweiten Variante, |
| Fig. 5 | eine stark vergrößerte Ansicht der Variante aus Fig. 4 gesehen in Richtung der Pfeile V-V, |
| Fig. 6a und 6b | eine den Fig. 4 und 5 entsprechende Ansicht einer auch für die Messung von Gleichspannungen geeigneten Variante, |
| Fig. 7 | einen der Fig. 2 entsprechenden Schnitt durch eine zweite, auf den Hochspannungsleiter aufsteckbare Ausführungsform der Sensoreinheit, |
| Fig. 8 | eine der Fig. 1 entsprechende Ansicht einer Sensoreinheit, die an einem Hilfsleiter befestigt ist, der an den Hochspannungsleiter anklemmbar ist, |
| Fig. 9 | einen der Fig. 2 entsprechenden Schnitt durch eine dritte Ausführungsform mit zwei Äquipotential-Elektroden, |
| Fig. 10 | einen dem oberen Teil der Fig. 1 entsprechenden Schnitt durch eine vierte, für mittlere Spannungen bis ca. 50 kV geeignete Ausführungsform der Sensoreinheit, |
| Fig. 11 | eine fünfte Ausführungsform einer erfindungsgemäßen Sensoreinheit, |

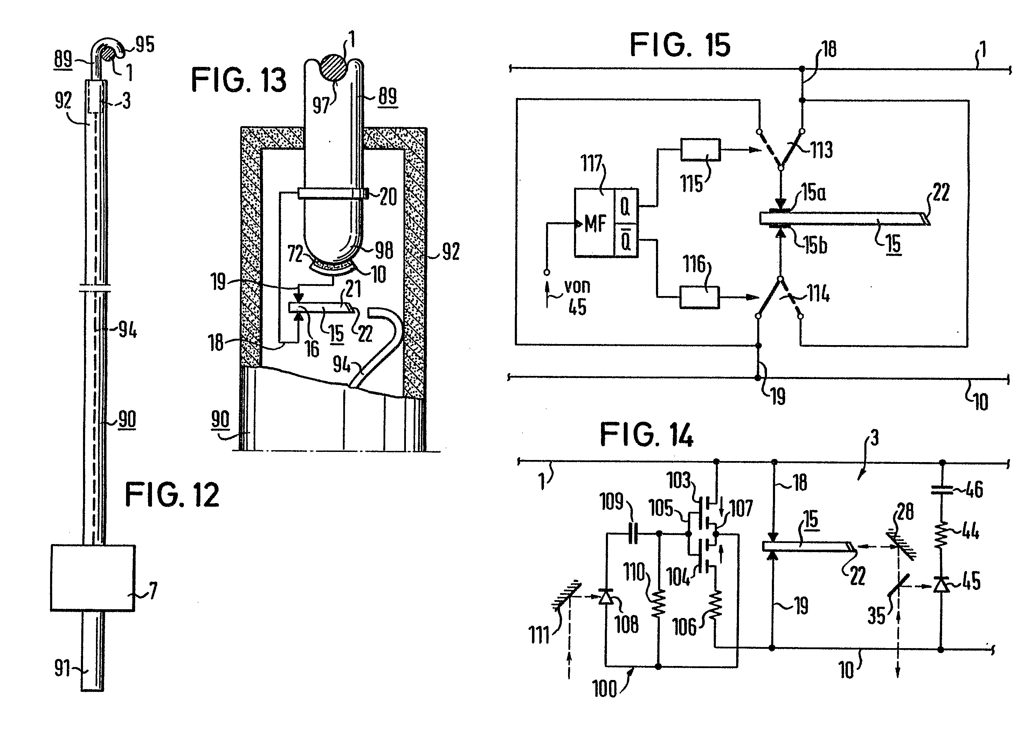

Fig. 12        eine Ausführungsform, bei der Meßgerät und Sensoreinheit durch eine isolierende, hohle Stange miteinander verbunden sind,

Fig. 13        in vergrößertem Maßstab das obere Ende der Stange aus Fig. 12 mit einem etwas anders geformten Hilfsleiter,

Fig. 14        ein schematisches Schaltungsdiagramm einer Sensoreinheit, die eine Nullpunkts-Schaltungsanordnung umfaßt,

Fig. 15        eine gegenüber Fig. 14 abgewandelte Ausführungsform einer Nullpunkts-Schaltungsanordnung, und

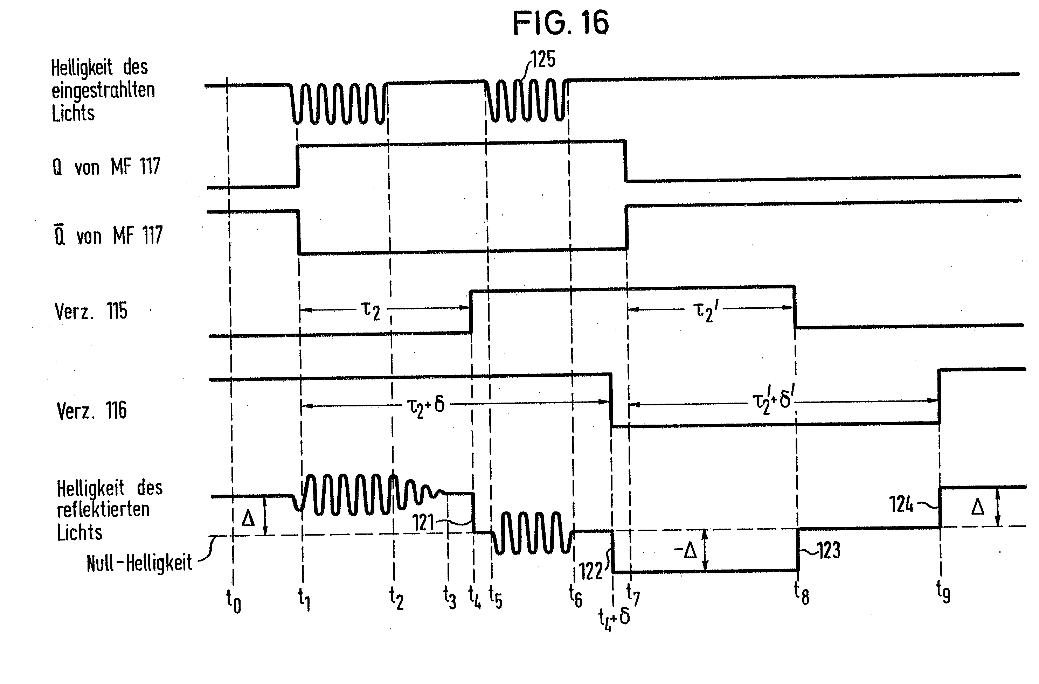

Fig. 16        ein Signaldiagramm zur Erläuterung der Funktionsweise der Schaltung aus Fig. 15.

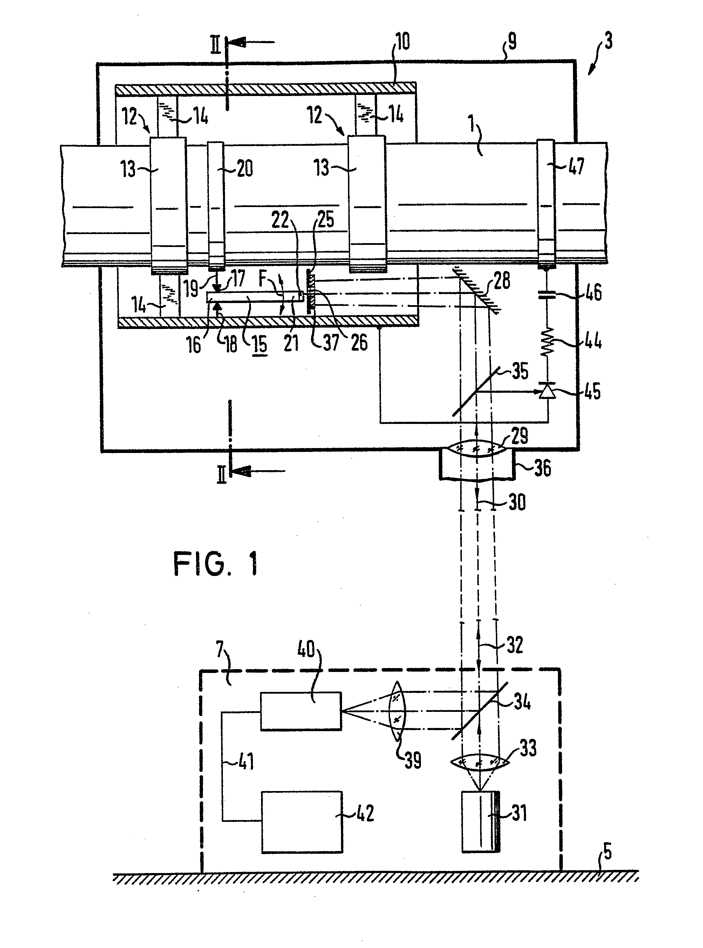

In Fig. 1 ist eine für Spannungen größer 50 kV besonders geeignete Ausführungsform einer erfindungsgemäßen Meßanordnung dargestellt, die aus einer am Hochspannungsleiter 1 befestigten Sensoreinheit 3 und einem von der Sensoreinheit 3 völlig getrennten, transportablen und auf dem Erdboden 5 aufstellbaren Meßgerät 7 besteht.

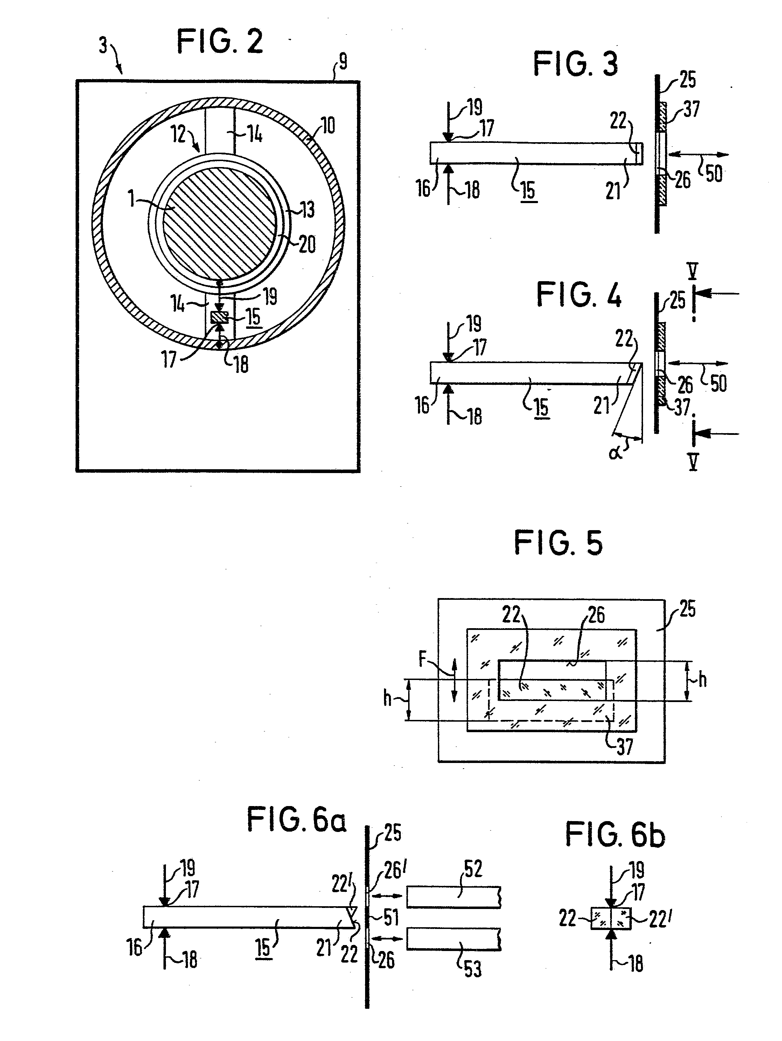

Die Sensoreinheit 3 umfaßt innerhalb eines nur schematisch angedeuteten hermetisch dichten Schutzgehäuses 9 aus nichtleitendem Material eine Elektrode 10 aus Metall, die, wie man insbesondere auch der Fig. 2 entnimmt, die Form eines hohlen Kreiszylinders von etwa 3 cm Länge und mit einem Durchmesser von etwa 3 cm besitzt und den Hochspannungsleiter 1 konzentrisch umgibt. Diese Maße sind so gewählt, daß sich bei einem Hochspannungsleiter von 60 kV bei einer Frequenz von 50 Hz zwischen dem hier als Referenzelektrode dienenden Hochspannungsleiter 1 und der Elektrode 10, die sich
auf einer Äquipotentialfläche befindet, eine Spannung
von ca. 100 V abgreifen läßt.

Um die Elektrode 10 in ihrer genauen konzentrischen Anordnung zum Hochspannungsleiter 1 zu halten, sind zwei Elektrodenhalter 12 aus nichtleitendem Material vorgesehen,
von denen jeder aus einer den Hochspannungsleiter 1 umschließenden Manschette 13 und hiervon radial abstehenden
Abstandsstücken 14 besteht,    mit deren äußerem Ende die
Elektrode 10 fest verbunden ist.

Zwischen dem Hochspannungsleiter 1 und der Elektrode 10
ist ein Piezoschwinger 15 angeordnet, der die Form eines
langgestreckten, im Querschnitt rechteckigen Stäbchens besitzt. Der Piezoschwinger 15 ist in der Nähe seines einen
Endes 16 in einer durch zwei Pfeilspitzen angedeuteten
Halterung 17 so eingespannt, daß sich seine Längsachse
im wesentlichen parallel zur Längsachse des Hochspannungsleiters 1 erstreckt.

Bei der schematischen Darstellung der Fig. 1 und 2 wird
davon ausgegangen, daß die Halterung 17 aus Metall besteht und daß ihr unterer Teil 18 elektrisch leitend mit
der Elektrode 10 verbunden ist, während ihr oberer Teil
19 über eine leitende Manschette  20 mit dem Hochspannungsleiter 1 verbunden ist. Die beiden Halterungsteile 18,19
sind nach außen hin elektrisch isoliert.
Durch diese Anordnung liegt an dem Piezoschwinger 15 dann,
wenn der Hochspannungsleiter 1 Spannung führt, eine Wechselspannung an, die zur Spannung des Hochspannungsleiters
proportional ist.

Es stehen Piezoschwinger zur Verfügung, die es ermöglichen, für die gesamte eben beschriebene Anordnung zwischen
Hochspannungsleiter 1 und Elektrode 10 eine Kapazität von
weniger als 100 pF zu erzielen. Die dargestellte Elektrode
10 besitzt gegenüber Erde eine Kapazität von etwa 2 pF,
so daß man hier einen kapazitiven Spannungsteiler erhält,
der in der Lage ist, genügend Leistung aufzunehmen, um
den Piezoschwinger 15 in Richtung des Doppelpfeiles F
zu Biegeschwingungen anzuregen, deren Amplitude zur Amplitude der im Hochspannungsleiter 1 geführten Spannung
proportional ist.

Das freie Ende 21 des Piezoschwingers 15 trägt eine Spiegelschicht 22. Unmittelbar vor dem freien Ende 21 ist eine
Blende 25 angeordnet, deren Öffnung 26 sowohl in Bewegungsrichtung des Piezoschwingers als auch senkrecht hierzu in
etwa dieselben Abmessungen besitzt, wie die ihr zugewandte
Spiegelschicht 22.

Die Blendenöffnung 26 und der sie unmittelbar umgebende Bereich der Blende/25 werden über einen Umlenkspiegel 28
und eine Linse 29 ins Unendliche abgebildet. Vorzugsweise
kann statt des Spiegels 28 auch ein Pentagonprisma verwendet werden, dessen Ablenkwinkel $90^{\circ}$ beträgt, wodurch
eine Invarianz des Strahlengangs gegen Drehungen dieser Umlenkvorrichtung um eine zur Zeichenebene der Fig. 1 senkrechte Achse erzielt werden kann.

Der Umlenkspiegel 28 ist in einer nicht näher dargestellten
Weise im Schutzgehäuse 9 so befestigt, daß der von der
Blende 25 ausgehende horizontale Strahlengang senkrecht
nach unten umgelenkt wird, wo er auf die in der Bodenwand
des Schutzgehäuses 9 befestigte Linse 29 trifft, die ihn
in ein paralleles Strahlenbündel 30 umwandelt.

Statt eines freien Strahlenganges zwischen der Spiegelfläche 22 und der Linse 29 kann hier auch eine Lichtleitfaser Verwendung finden, deren eines Ende in der Weise
fest angebracht wird, daß es in der Ruhelage des Piezoschwingers 15 der Spiegelfläche 22
gegenübersteht. Diese Stirnfläche der Lichtleitfaser bildet das Äquivalent zur Blendenöffnung 26. Das andere Ende
dieser Lichtleitfaser ist in einem Abstand zur Linse 29
so anzuordnen, daß das aus der Lichtleitfaser austretende Lichtbündel parallelisiert wird. In diesem Fall
besitzt die Linse 29 eine wesentlich kürzere Brennweite
als bei dem in Fig. 1 dargestellten Ausführungsbeispiel.

Diese Lichtleitfaser kann aber auch so lang ausgebildet
sein, daß ihr vom Sensor 15 abgewandtes Ende gefahrlos
zugänglich ist und mit dem optischen Aus- und Eingang des
Meßgerätes 7 verbunden werden kann.

Sowohl durch die Blende 25 als auch durch die Lichtleitfaser wird der Einfluß von mechanischen Schwingungen des
Hochspannungsleiters auf das Meßergebnis weitgehend ausgeschaltet, da die Aufhängung des Piezoschwingers ihnen
in gleicher Weise ausgesetzt ist, wie die Blende 25 bzw.
die Lichtleitfaser, in das Meßergebnis aber nur Relativbewegungen dieses Bauteils gegen den Piezoschwinger 15 eingehen.

Das am Boden 5 befindliche, frei bewegliche Meßgerät 7
umfaßt einen Lichtsender 31, der als Lichtquelle vorzugsweise einen Laser sowie eine wahlweise ein- und ausschaltbare Modulationsvorrichtung für das vom Laser emittierte
Lichtbündel 32 besitzt. Dieses Lichtbündel 32 wird mit
Hilfe einer schematisch als einzelne Linse 33 dargestellten optischen Einheit parallelisiert und verläßt durch
einen halbdurchlässigen Spiegel 34, der für das emittierte Lichtbündel ohne Funktion ist, das Meßgerät 7.

0165489

Das vom Laser emittierte Lichtbündel 32 wird durch die
von einem Streulichtschutz 36 umgebene  Linse 29 durch
einen halbdurchlässigen Auskoppelspiegel 35 hindurch
und über den Umlenkspiegel 28 auf die Blendenöffnung 26
und die dahinter befindliche Spiegelschicht 22 fokussiert.
Der Querschnitt des Brennflecks ist so gewählt, daß er
etwas größer ist als die Blendenöffnung 26, so daß ein
Teil des Lichtes auch auf eine Spiegelschicht 37 trifft,
die die Blendenöffnung 26 auf der Seite der Blende 25
umgibt, die dem Umlenkspiegel 28 und damit dem Lichtsender 31 zugewandt ist. Die Spiegelschichten 37 und 22
sind in den Figuren, in denen sie in Seitenansicht dargestellt sind, der Deutlichkeit halber mit einer stark
vergrößerten Dicke wiedergegeben. In der Praxis werden
hier vorzugsweise aufgedampfte Spiegelschichten verwendet.

Das von der Linse 29 zum Meßgerät 7 zurückprojizierte
parallele Lichtbündel 30 wird vom Umlenkspiegel 34 zu
einer Linse 39 umgelenkt, die es auf einen photoelektrischen Empfänger 40 abbildet, dessen Ausgangssignal über
eine Leitung 41 einer Auswerte- und Anzeigeschaltung
42 zugeführt wird.

Der vom halbdurchlässigen Umlenkspiegel 35 in der Sensoreinheit 3 ausgekoppelte Teil des Lichtbündels 32
trifft auf eine Photodiode 45, deren einer Anschluß
über einen Schutzwiderstand 44, einen Gleichspannungsanteile unterdrückenden Kondensator 46 und eine leitende
Manschette 47 mit dem Hochspannungsleiter 1 in Verbindung steht, während ihr anderer Anschluß mit der Elektrode 10 leitend verbunden ist.

Die Photodiode 45, ihr Schutzwiderstand 44 und der Kondensator 46 sind in Fig. 1 nur der Deutlichkeit halber außerhalb des Zwischenraums zwischen dem Hochspannungsleiter 1 und der Elektrode 10 dargestellt. In der Praxis wird man diese elektronischen Bauteile ebenso wie den Spiegel 35, der dann im Strahlengang hinter dem Umlenkspiegel 28 liegt, in dem Freiraum zwischen Hochspannungsleiter 1 und Elektrode 10 unterbringen, um möglichst kurze, geradlinige, sich längs der Feldlinien erstreckende Leiter verwenden zu können und das Auftreten von Sprühentladungen weitgehend zu reduzieren. Gegebenenfalls kann man dann auch auf die zusätzliche Manschette 47 verzichten und die zweite leitende Verbindung der Photodiode 45 zum Schwinger 15 über die Manschette 20 herstellen.

Bei der folgenden Schilderung der Arbeitsweise der erfindungsgemäßen Vorrichtung wird davon ausgegangen, daß Sensoreinheiten 3 an Hochspannungsleitern 1, beispielsweise den Drähten von Überlandleitungen an Stellen fest installiert sind, an denen die Spannung gemessen bzw. das Anliegen oder Nichtanliegen von Spannung überprüft werden soll. Zur Durchführung einer solchen Messung wird das Meßgerät 7 unter der entsprechenden Sensoreinheit 3 auf dem Boden so positioniert, daß das von ihr emittierte Lichtbündel 32 senkrecht nach oben auf die Linse 29 der Sensoreinheit trifft. Um eine entsprechende Positionierung vornehmen zu können, kann das Meßgerät 7 auf einem schwenkbaren Stativ angeordnet oder mit höhenverstellbaren Beinen versehen sein, oder es kann der Lichtsender 31 im Meßgerät 7 kardanisch aufgehängt sein, so daß die Richtung des Lichtbündels 32 immer mit der Vertikalen in Übereinstimmung gebracht werden kann. Weiterhin kann das Meßgerät 7 ein ebenfalls nicht dargestelltes Zielfernrohr umfassen, mit dessen Hilfe ein genaues Anpeilen der Sensoreinheit 3 ermöglicht wird.

Ist das Meßgerät 7 in die richtige Stellung gebracht,
so wird zunächst der Lichtsender 31 dazu veranlaßt, ein
nichtmoduliertes Lichtbündel 32 auszusenden, das in der
bereits beschriebenen Weise über die aus der Linse 29
und dem Umlenkspiegel 28 bestehende Projektionsvorrichtung auf die Blendenöffnung 26 und die dahinterliegende
Spiegelschicht 22 am freien Ende 21 des Piezoschwingers
15 gelenkt wird.

Liegt am Hochspannungsleiter 1 eine Wechselspannung
an, so schwingt, wie oben bereits erwähnt, das freie
Ende 21 des Piezoschwingers 15 auf und ab, so daß die
Blendenöffnung 26 durch das von der Spiegelfläche 22
reflektierte Licht mit entsprechend schwankender Helligkeit ausgeleuchtet wird. Da die Blendenöffnung 26 über
den Umlenkspiegel 28, die Linse 29, den Umlenkspiegel
34 und die Linse 39 auf den photoelektrischen Empfänger
40 abgebildet wird, führen diese Helligkeitsschwankungen,
deren Amplitude proportional zu der am Hochspannungsleiter 1 anliegenden Spannung ist, zu entsprechenden
Schwankungen des Ausgangssignals des photoelektrischen
Empfängers 40. Die Größe der Amplitude dieses Ausgangssignals wird von der Auswerte- und Anzeigeeinheit 42
zunächst gemessen und gespeichert.

Da, wie bereits erwähnt, der Querschnitt des/Lichtbündels
32 so gewählt ist, daß auch ein Teil der die Blendenöffnung 26 umgebenden Spiegelfläche 37 beleuchtet wird,
enthält das auf den Photoempfänger 40 projizierte Licht
einen Gleichlichtanteil, da die Blende 25 feststehend angeordnet ist. Die Helligkeit dieses Gleichlichtanteiles
hängt von der Transparenz der gesamten Meßstrecke ab, die
beispielsweise durch Vereisung, Beschlagen, oder Verschmutzung der Linse 29, des Umlenkspiegels 28 oder der
Spiegelschicht 22 sowie durch unterschiedlichen Feuchtigkeitsgehalt der in der Meßstrecke zwischen dem Meßgerät 7 und der Sensoreinheit 3 befindlichen Luftsäule beeinflußt werden kann. Alle diese Einflüsse können mit Hilfe
des vom photoelektrischen Empfänger 40 empfangenen Gleichlichtanteiles dadurch eliminiert werden, daß man entweder
den Gleichlichtanteil mißt und mit Hilfe dieses Meßwertes
die gemessene Wechsellichtamplitude korrigiert, oder daß
der Gleichlichtanteil zu einer Intensitätsregelung des
vom Lichtsender 31 emittierten Lichtbündels 32 verwendet
wird.

Nach Speicherung des so korrigierten Amplitudenwertes
der durch das Hochspannungs-Wechselfeld erzwungenen
Schwingung des Sensors mit 50 Hz oder 60 Hz wird statt
des unmodulierten Meßlichts ein Lichtbündel vom Meßgerät
7 zur Sensoreinheit 3 projiziert, das mit einem Signal
helligkeitsmoduliert ist, dessen Frequenz der Resonanzfrequenz von beispielsweise 1.500 Hz des Schwingkreises
entspricht, der von der Photodiode 45 mit dem Piezoschwinger 15 über die Impedanzen der Verbindungsleitungen und die Kapazität zwischen Elektrode 10 und Hochspannungsleiter 1 gebildet wird. Dieses Anregungssignal
gelangt über den halbdurchlässigen Auskoppelspiegel 35
auf die photovoltaisch arbeitende Photodiode 45. Hierdurch wird dem Piezoschwinger 15 eine zusätzliche Schwingung mit der entsprechend hohen Frequenz von 1.500 Hz
aufgeprägt, die zu einer zusätzlichen Modulation des
reflektierten Lichtbündels 30 führt. Schaltet man das
Anregungssignal ab und sendet wieder unmoduliertes Licht,
so schwingt der Piezoschwinger 15 mit abnehmender Amplitude in einer gedämpften Schwingung nach und das entsprechende, vom Empfänger 40 abgegebene Signal kann
aufgrund seiner von der Frequenz des Hochspannungs-Wechselfeldes stark verschiedenen Frequenz ohne weiteres
elektrisch ausgefiltert und gesondert verarbeitet werden.
Zunächst kann seine Amplitude aufgrund des bereits gewonnenen Gleichlichtanteils von den Einflüssen der Lufttransparenz und ähnlichem befreit werden und es kann die
so korrigierte Amplitude dazu verwendet werden, die
Temperaturabhängigkeit des eigentlichen Meßlichtsignals
zu beseitigen, weil die Temperatur des Piezoschwingers
15 die beiden Schwingungen in entsprechender Weise beeinflußt.

Somit läßt sich, eventuell mit Hilfe von zuvor gewonnenen Eichwerten, das mit dem unmoduliert ausgesandten
Lichtbündel gewonnene Wechsel-Ausgangssignal des Empfängers 40 so korrigieren, daß es eine genaue Anzeige
für die am Hochspannungsleiter 1 anliegende Spannung
darstellt.

Enthält das von der Sensoreinheit 3 bei Aussenden eines
unmodulierten Lichtbündels zum photoelektrischen Empfänger 40 reflektierte Licht keinen Wechsellichtanteil,
so kann dies bedeuten, daß entweder am Hochspannungsleiter 1 keine Hochspannung anliegt oder daß die Sensoreinheit 3 defekt ist. Um zwischen diesen beiden
Fällen unterscheiden zu können, wird wieder das eben
geschilderte Anregungssignal ausgesandt, das dann,
wenn die Sensoreinheit 3 einwandfrei funktioniert, den
Piezoschwinger 15 zu einer entsprechenden Resonanzschwingung anregt, so daß ein hochfrequent moduliertes
Reflexionssignal empfangen werden kann. Auch hier besteht
die Möglichkeit, den Lichtsender 31 sehr schnell von
der Emission von moduliertem Licht auf die Emission von
Dauerlicht umzuschalten und die Modulation des von der
Sensoreinheit 3 reflektierten Lichtes zu beobachten,
die darauf beruht, daß der Piezoschwinger 15 noch etwas
nachschwingt, nachdem die Photodiode 45 nicht mehr
weiter angeregt wird.

In jedem Fall läßt sich auf diese Weise eindeutig entscheiden, ob die Sensoreinheit 3 funktionsfähig ist oder
nicht.

Diese Kontrollmöglichkeit besteht auch dann, wenn statt
des mechanischen Piezoschwingers 15 ein anderer Sensor,
beispielsweise ein PLZT-Plättchen verwendet wird, das
seine Lichtdurchlässigkeit bzw. sein Streuverhalten in
Abhängigkeit vom umgebenden Wechselfeld ändert und hinter
dem (in Richtung des einfallenden Lichtbündels 32 gesehen)
ein Spiegel angebracht ist. In diesem Fall muß durch eine
entsprechende elektrische Beschaltung dafür gesorgt werden,
daß man insgesamt ein durch die Photodiode 45 zu einer
Eigenschwingung anstoßbares schwingungsfähiges System
erhält.

In Fig. 3 ist nur ein eingespannter Piezoschwinger 15
und die vor seiner freien Stirnfläche angeordnete Blende
25 in einer der Fig. 1 entsprechenden Ansicht, jedoch stark
vergrößert dargestellt. Bei dieser Variante ist die Anordnung so getroffen, daß die Längsmittelachse des Sensors
15 in seiner Ruhelage genau mit der durch den Doppelpfeil
50 angedeuteten optischen Achse der Projektionseinrichtung
fluchtet. Die Blende 25 ist so angeordnet, daß die Mitte
ihres Schlitzes 26 mit der optischen Achse 50 zusammenfällt. Die Höhe des Schlitzes 26 ist dabei größer als die
maximale Gesamtauslenkung (nach oben und unten) des freien
Endes 21 des Piezoschwingers 15. Bei dieser Anordnung
wird ein eingestrahltes Lichtbündel mit der doppelten
Frequenz des Hochspannungs-Wechselfeldes helligkeitsmoduliert, weil sich bei der in Fig. 3 dargestellten Ruhe- bzw.
Mittellage, die dem Nulldurchgang des Hochspannungs-Wechselfeldes entspricht, eine maximale Helligkeit ergibt und sowohl bei einer Auslenkung nach oben (beispielsweise Maximum des Hochspannungs-Wechselfeldes) als auch bei einer Auslenkung nach unten (beispielsweise Minimum des Hochspannungs-Wechselfeldes) jeweils ein Helligkeitsminimum durchlaufen wird. Bei der dargestellten Ausführungsform wird die Helligkeitsmodulation des eingestrahlten Lichtbündels im wesentlichen durch die Verkippung der in der gezeichneten Ruhelage senkrecht zur optischen Achse 50 verlaufenden Spiegelschicht 22 bewirkt.

Will man die oben beschriebene Frequenzverdoppelung vermeiden, so kann die in den Fig. 4 und 5 dargestellte Variante gewählt werden. Hier besitzt die Spiegelschicht in der durch einen Doppelpfeil F gekennzeichneten Bewegungsrichtung des Piezoschwingers eine Höhe h, die in etwa gleich der doppelten maximalen Auslenkung des freien Endes 21 des Piezoschwingers 15 bei Nennspannung am Hochspannungsleiter 1 ist. In den Fig. 4 und 5 ist wieder die Ruhe- oder Nulldurchgangsstellung dargestellt, in der bei dieser Ausführungsform die untere Hälfte der Spiegelschicht 22 vom unteren Teil der Blende 25 abgedeckt wird und die mit der unteren Hälfte der ebenfalls die Höhe h besitzenden Blendenöffnung 26 fluchtende obere Hälfte der Spiegelschicht 22 Licht zum Meßgerät 7 reflektiert. Folgt auf diesen Zustand eine positive Halbwelle der Hochspannung, so bewegt sich das freie Ende 21 des Piezoschwingers 15 nach oben, wodurch ein immer größer werdender Teil der oberen Hälfte der Blendenöffnung 26 von der Spiegelschicht 22 überdeckt wird, bis schließlich bei Erreichen der maximalen positiven Spannungsamplitude die ganze Blendenöffnung 26 von der Spiegelschicht 22 erfüllt ist.

Die Spiegelschicht 22 ist um einen Winkel α gegen die zur Längsachse des Piezoschwingers 15 senkrechte Richtung so geneigt, daß sie bei maximaler Auslenkung nach oben auf der optischen Achse 50 senkrecht steht. Somit wird das gesamte auf die Blendenöffnung 26 fallende Licht zum Meßgerät 7 reflektiert und dieses empfängt die maximale Helligkeit. Folgt dagegen auf den in Figur 4 gezeigten Zustand eine negative Spannungshalbwelle, so wird die Spiegelschicht 22 nach unten bewegt, so daß ihr durch die Blendenöffnung 26 hindurch wirksamer Teil immer kleiner wird, bis sie schließlich bei Erreichen der maximalen negativen Spannungsamplitude völlig aus der Blendenöffnung 26 verschwunden ist. In dieser Stellung wird von dem auf die Öffnung 26 fallenden Licht nichts mehr zum Meßgerät reflektiert. Dies ergibt dann die minimale am Meßgerät 7 empfangbare Helligkeit. Führt der Piezoschwinger 15 aufgrund eines periodischen Hochspannungswechselfeldes eine periodische Schwingung aus, so wird also das von der Spiegelschicht 22 reflektierte Licht in entsprechender Weise periodisch in seiner Helligkeit moduliert.

Statt die Spiegelfläche 22 in der in Fig. 4 gezeigten Weise unter einem Winkel α zu neigen, ist es erfindungsgemäß auch möglich, sie so wie in Fig. 3 dargestellt, senkrecht zur Längsachse des Piezoschwingers 15 auszurichten und statt dessen den Piezoschwinger bei 17 mechanisch so einzuspannen, daß in der Ruhe- bzw. Nulldurchgangsstellung seine Längsachse unter einem entsprechenden Winkel zur optischen Achse 50 geneigt ist, so daß die Spiegelschicht 22 wieder die in der Fig. 4 dargestellte Lage einnimmt.

In den Fig. 6a und 6b ist eine weitere, besonders zur
Messung von Gleichspannungen geeignete Variante dargestellt, wobei Fig. 6a den Darstellungen in den Fig. 3
und 4 entspricht und Fig. 6b die Stirnfläche des freien
Endes 21 des Piezoschwingers 15 zeigt, wie sie in Fig.
6a bei weggelassener Blende 25 von rechts gesehen erscheint. Diese Variante unterscheidet sich von dem für
Wechselspannung geeigneten Varianten im wesentlichen dadurch, daß die Blende 25 zwei Schlitze 26, 26' aufweist,
die in Bewegungsrichtung des Piezoschwingers 15 voneinander im Abstand angeordnet und durch einen Steg 51 getrennt sind, der in der Ruhelage des Piezoschwingers 15,
d.h. ohne anliegende Hochspannung, die Stirnfläche des
freien Endes 21 abdeckt. Die Breite der Schlitze
26, 26' ist so gewählt, daß sie bei anliegender Nennspannung mit der Stirnfläche des dann maximal ausgelenkten Piezoschwingers 15 zur Deckung kommen, wobei
der eine Schlitz zu Erkennung und Messung einer positiven
und der andere zur Erkennung und Messung einer negativen
Gleichspannung dient. Um diese beiden Spannungsvorzeichen
voneinander unterscheiden zu können, sind zwei Lichtleitfasern 52, 53 vorgesehen, deren Stirnenden den Schlitzen
26' bzw. 26 gegenüberliegen. Um auch hier bei maximaler
Auslenkung zu einer maximalen Helligkeit zu kommen, ist
die Stirnfläche des freien Endes 21 in zwei Hälften unterteilt, die jeweils eine Spiegelschicht 22 bzw. 22' tragen,
die unterschiedlicher Weise so geneigt sind, daß die eine
bei der Auslenkung nach oben und die andere bei der Auslenkung nach unten senkrecht zur jeweiligen optischen Achse
steht. Ein entsprechender Effekt kann auch dadurch erzielt werden, daß nur eine einzige, zur Längsachse des
Piezoschwingers senkrechte Spiegelfläche 22 vorgesehen
wird und die beiden optischen Achsen durch eine entsprechende Ausrichtung der Lichtleitfasern 52, 53 geneigt
werden. Hier ist die Spiegelschicht 37, die bei den zur Wechselspannungsmessung dienenden Varianten gemäß den Fig.
3 bis 5 auf der Blende 25 angebracht ist, weggelassen,
weil der durch diese Spiegelschicht reflektierte Gleichlichtanteil von dem von den Spiegelschichten 22 bzw. 22'
reflektierten Licht nicht getrennt werden kann, wenn nicht
noch eine weitere Lichtleitfaser verwendet werden soll,
oder die weiter unten unter Bezugnahme auf die Fig. 14, 15
und 16 erläuterten Maßnahmen ergriffen werden.

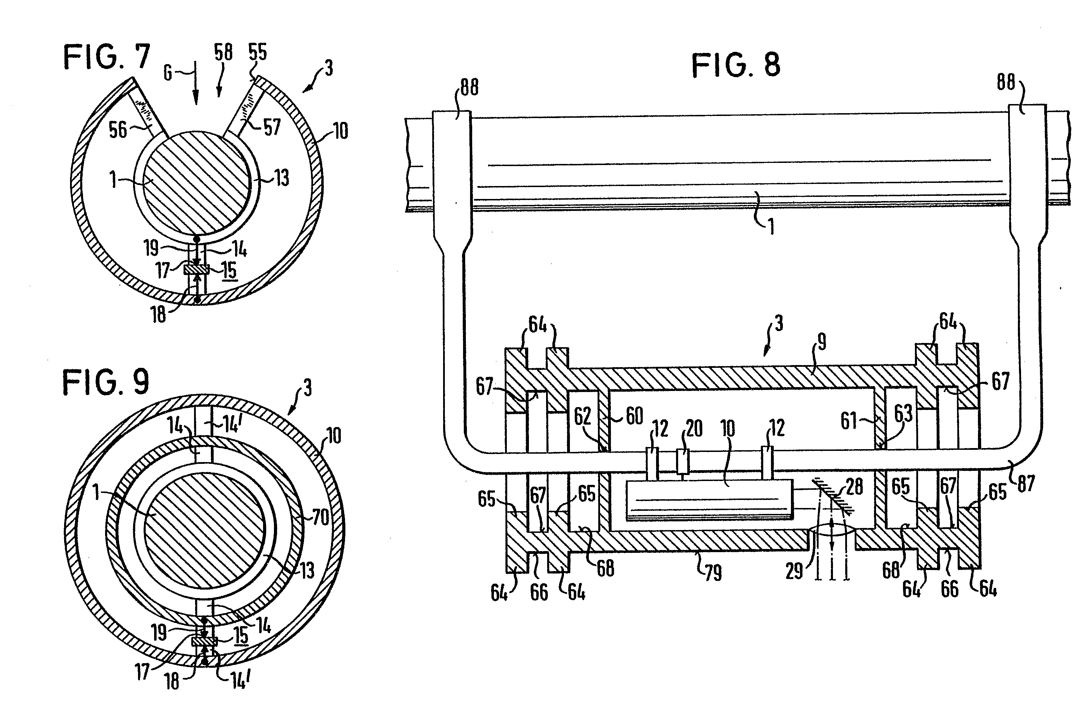

Fig. 7 zeigt eine der Fig. 2 entsprechende Ansicht einer
anderen Ausführungsform einer erfindungsgemäßen Sensoreinheit 3, wobei das Schutzgehäuse 9 weggelassen ist, und
gleiche Teile mit denselben Bezugszeichen versehen sind.
Zur Vermeidung von Wiederholungen werden diese bereits
beschriebenen Teile nicht nochmals erläutert, sondern es
wird nur auf die Unterschiede eingegangen.

Die in Fig. 7 gezeigte Sensoreinheit 3 ist zur Durchführung
einer Messung auf den Hochspannungsleiter 1 aufsteckbar und
kann danach wieder abgezogen werden. Zu diesem Zweck ist
die hohlzylindrische Elektrode 10 an ihrer Oberseite längs
einer Mantellinie mit einem sich über ihre gesamte axiale
Länge erstreckenden Schlitz 55 versehen. Das in Fig. 2
dargestellte vertikale Abstandsstück 14 ist hier weggelassen.
Statt dessen erstreckt sich von jeder der Schlitzkanten ein
Abstandsstück 56 bzw. 57 radial nach innen zur Manschette
13, die hier in Form einer nach oben offenen C-förmigen
Klammer ausgebildet ist, deren Enden in die Abstandsstücke
56 bzw. 57 übergehen. Auf diese Weise wird ein oben offener
Einschubweg 58 geschaffen, in welchen der Hochspannungsleiter 1 beim Aufstecken dieser Sensoreinheit 3 in Richtung
des Pfeils G eingeführt werden kann. Wird hierauf die Sensoreinheit 3 gegen den Hochspannungsleiter 1 nach oben
gedrückt, so federn die Elektrode 10, die Abstandsstücke
56, 57 und die Manschette 13 elastisch auseinander, wodurch der Hochspannungsleiter 1 relativ zur Sensoreinheit 3 nach unten bis in den zentralen Durchgang der Manschette
13 gleiten kann. Hat er die in Fig. 7 wiedergegebene
Stellung erreicht, so verengt sich der Einschubweg 58
wieder auf seine ursprüngliche Weite und es tritt eine
Rastwirkung ein, weil die Weite der obenliegenden Öffnung
der C-förmigen Manschette 13 etwas geringer als der Durchmesser des Hochspannungsleiters 1 ist. Da bei einer erfindungsgemäßen Sensoreinheit 3 wenigstens zwei derartig
ausgebildete Elektrodenhalter 12 vorgesehen und in axialer
Richtung voneinander so beabstandet angeordnet sind, wie
dies in Fig. 1 für die Elektrodenhalter 12 dargestellt
ist, ergibt sich ein fester Sitz der Sensoreinheit 3 auf
dem Hochspannungsleiter, der gewährleistet, daß die
Elektrode 10 während der Messung einen definierten Abstand
zum Hochspannungsleiter 1 einnimmt. Außerdem ist bei dieser
Ausführungsform die dargestellte C-förmige Manschette 13
aus elektrisch leitendem Material hergestellt, so daß sie
gleichzeitig zur Verbindung des Sensors 15 und der hier
nicht dargestellten Photodiode (und deren zugehöriger
Schaltungselemente) mit dem Hochspannungsleiter 1 dient.

Diese Ausführungsform kann auch für eine nachträgliche,
dauerhafte Montage der Sensoreinheit in Räumen Verwendung
finden, in denen keine Verschmutzungsgefahr besteht.

In Fig. 8 ist eine Ausführungsform der erfindungsgemäßen
Sensoreinheit 3 dargestellt, bei der die Referenzelektrode
von einem Hilfsleiter 87 gebildet wird, der im wesentlichen U-förmig ausgebildet ist und an den Enden
seiner beiden Schenkel jeweils eine metallische Klammer
88 trägt, mit deren Hilfe er auf den Hochspannungsleiter
1 so aufgesteckt werden kann, daß sich der zwischen den
beiden Schenkeln verlaufende Teil im wesentlichen parallel zum Hochspannungsleiter erstreckt. Die Krümmungen, mit denen dieser Teil in die beiden Schenkel übergeht, können je nach der am Hochspannungsleiter 1 anliegenden Spannung wesentlich flacher verlaufen, als dies in Fig. 8 dargestellt ist, um Sprühentladungen zu vermeiden. Der Kontakt zwischen den Klammern 88 und dem Hochspannungsleiter 1 ist nicht kritisch, weil er im wesentlichen nur zur Potentialübertragung dient und die durch die Sensoreinheit 3 vom Hochspannungsleiter 1 aufgenommene Leistung außerordentlich gering ist.

Da die in Fig. 8 dargestellte Sensoreinheit 3 für eine nachträgliche dauerhafte Montage an einem Hochspannungsleiter im Freien gedacht ist, ist das Schutzgehäuse 9 erfindungsgemäß so ausgebildet, daß es nicht aufgrund von Verschmutzung zu einer Verschleppung des Potentials des Hochspannungsleiters 1 und des Hilfsleiters 87 auf die Gehäuseoberfläche und damit zu einer Verfälschung des Meßergebnisses kommen kann. Erfindungsgemäß können auch die in den Fig. 1, 2 und 10 nur schematisch angedeuteten Gehäuse so ausgebildet sein, wie dies in der Fig. 8 im einzelnen dargestellt ist.

Das hier gezeigte Gehäuse 9 besitzt im wesentlichen die Form eines hohlen Kreiszylinders, der konzentrisch zum Hilfsleiter 87 angeordnet ist. In axialer Richtung ist der Innenraum des Gehäuses 9 durch zwei Stirnwände 60, 61 abgeschlossen, die in ihrer Mitte Durchgangsöffnungen 62, 63 aufweisen, durch die der Hilfsleiter 87 in hermetisch dichter Weise hindurchgeführt ist. Somit trägt der Hilfsleiter 87 das Gehäuse 9 über die Stirnwände 60, 61 in einer genau definierten Lage. Die Zylinderwand des Gehäuses 9 steht über die Stirnwände 60, 61 in axialer Richtung nach außen vor und besitzt an beiden Enden sowohl auf ihrer radial äußeren als auch auf ihrer radial inneren

Oberfläche in Umfangsrichtung verlaufende radial abstehende Vorsprünge 64, 65, die durch ebenfalls in Umfangsrichtung um das gesamte Gehäuse herum verlaufende Nuten bzw. Vertiefungen 66 bzw. 67 voneinander in axialer Richtung getrennt sind. Auch der in axialer Richtung jeweils am nächsten bei der Stirnwand 60 bzw. 61 liegende, radial nach innen gerichtete Vorsprung 65 ist von der ihm benachbarten Stirnwand 60 bzw. 61 durch eine umfangsmäßig verlaufende Nut 68 getrennt. Durch diese Anordnung wird verhindert, daß sich ein zusammenhängender Schmutz- oder Feuchtigkeitsfilm ausgehend vom Hilfsleiter 87 bis auf die außenliegende Mantelfläche 79 des Gehäuses 9 erstrecken und dadurch die Potentialverteilung verzerren kann, der die Elektrode 10 ausgesetzt wird.

Bei dem in Fig. 8 wiedergegebenen Ausführungsbeispiel bildet die Elektrode 10 keinen geschlossenen Hohlkörper sondern besitzt die Form einer unter dem Hilfsleiter 87 an den Elektrodenhaltern 12 aufgehängten, nach oben offenen Wanne, deren Querschnittskonfiguration an den Verlauf einer hier abzutastenden Äquipotentialfläche angepaßt ist. Da es in dem zwischen dem Hochspannungsleiter 1 und dem Hilfsleiter 87 liegenden Raumbereich zu einer Verzerrung des den Hochspannungsleiter 1 ansonsten radial symmetrisch umgebenden Feldes kommt, wird hier erfindungsgemäß die Elektrode 10 in der eben beschriebenen von der Halbkreiszylinderform abweichenden Weise ausgebildet, wobei ihre genaue Form durch entsprechende Versuche festgestellt werden muß, bei denen der Verlauf der Äquipotentialflächen im Einzelfall vorher bestimmt wird.
Der Sensor 15, die Blende 25 und die Photodiode 45 mit ihren Zusatzbauelementen sind im Inneren der in Fig. 8 nicht geschnitten dargestellten Elektrode 10 angeordnet, wie dies oben bereits beschrieben wurde. Da sich auch die Mantelfläche 79 des Gehäuses 9 nicht längs einer Äquipotentialfläche erstreckt, muß verhindert werden,
daß durch Verschmutzung oder Feuchtigkeit das Potential
von der dem Hochspannungsleiter 1 zugewandten Oberseite
dieser Mantelfläche 79 auf die dem Erdboden zugewandte
Unterseite verschleppt wird. Zu diesem Zweck erstrecken
sich auf der Außenseite des Gehäuses in Fig. 8 nicht
dargestellte Vorsprünge und dazwischenliegende Vertiefungen parallel zur Längsachse des Gehäuses 9 in der
Weise, daß sie die obere Gehäusehälfte von der unteren
"isolieren".

In Fig. 9 ist eine der Fig. 2 entsprechende Ansicht einer
vierten Ausführungsform dargestellt, bei welcher wiederum
gleiche Teile mit denselben Bezugszeichen bezeichnet sind.
Da es sich hierbei wieder um eine fest am Hochspannungsleiter 1 zu montierende Sensoreinheit 3 handelt, bildet
die Elektrode 10 einen geschlossenen Hohlzylinder,
in dessen Innerem eine zweite, hier die Referenzelektrode
bildende Elektrode 70 in Form eines zum Hochspannungsleiter 1 konzentrischen, hohlen Kreiszylinders angeordnet
ist. Die metallische Elektrode 70 erstreckt sich
längs einer Äquipotentialfläche des den Hochspannungsleiter
1 umgebenden Feldes und ist in axialer Richtung kürzer ausgebildet als die außenliegende Elektrode 10, um eine Abschirmwirkung zu vermeiden. Die beiden Elektroden sind
voneinander durch radial verlaufende isolierende Abstandsstücke 14
auf Abstand gehalten. Die innere Elektrode 70 ist wieder über
radial verlaufende Abstandsstücke 14 aus isolierendem Material
mit einer am Hochspannungsleiter 1 befestigten Manschette
13 verbunden. Bei dieser Anordnung befindet sich der Sensor 15 zwischen der inneren Elektrode 70 und der äußeren
Elektrode 10 und greift die zwischen diesen beiden Elektroden abfallende Spannung ab, die er in eine Beeinflussung des eingestrahlten Lichtbündels umsetzt.

Auch diese Ausführungsform kann so abgewandelt werden,
daß sie auf den Hochspannungsleiter 1 nur zur Durchführung einer Messung aufsteckbar und danach wieder abziehbar ist.

Die in den Fig. 1,2,7,8 und 9 dargestellten Ausführungsformen
sind insbesondere für große bis sehr große Hochspannungen
geeignet, weil sie durch ihren Aufbau eine äußerst kurze
Leitungsführung ermöglichen und sich mit Ausnahme der Anschlüsse 18 und 19 alle verwendeten Leiter längs Äquipotentialflächen erstrecken, so daß das Auftreten von
Sprühentladungen auf ein Minimum reduziert wird. Auch die
nach außen hin isolierten Leiter 18 und 19 durchlaufen nur ein geringes
Potentialgefälle, da sie erfindungsgemäß möglichst kurz ausgebildet werden. Es sei ausdrücklich darauf hingewiesen, daß
die in Fig. 1 für das erste Ausführungsbeispiel dargestellten Teile 28, 29 der Projektionsanordnung, die Blende 25 mit der Blendenöffnung 26 und der Spiegelschicht
37, der Auskoppelspiegel 35 und die Photodiode 45 mit
ihrer Beschaltung 44, 46 bei den Ausführungsbeispielen
gemäß den Fig. 7 und 9 in entsprechender Weise vorgesehen und angeordnet sind.

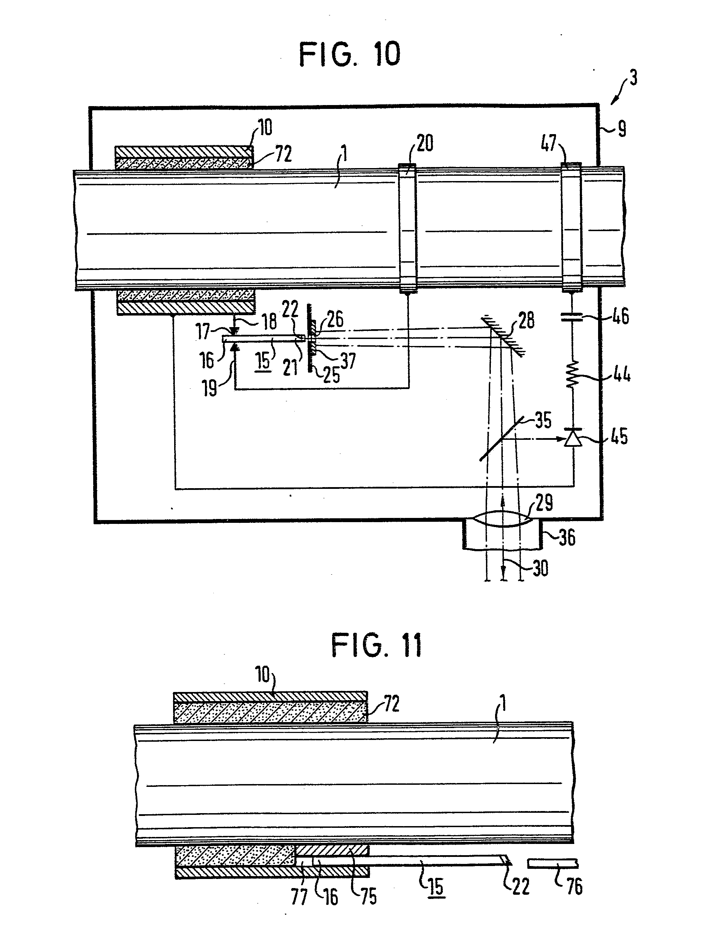

Diese Bestandteile der Sensoreinheit sind, wie man der
Fig. 10 entnimmt, auch bei einer weiteren Ausführungsform
vorgesehen, die sich von den bisher beschriebenen Beispielen im wesentlichen durch eine andere räumliche Anordnung des Piezoschwingers 15 bezüglich der Elektrode 10
unterscheidet.

Bei dieser Ausführungsform ist auf den Hochspannungsleiter
1 eine Schicht 72 aus isolierendem Material in unmittelbarem Kontakt aufgebracht, z.B. aufgewickelt, die den Hochspannungsleiter 1 konzentrisch umgibt. Auf die Außenseite
dieser isolierenden Schicht 72 ist in unmittelbarem Kontakt die Elektrode 10 aus leitendem Material aufgebracht, die durch die isolierende Schicht vom Hochspannungsleiter 1 auf einem definierten Abstand gehalten wird.

Auch hier besitzt die Elektrode 10 die Form eines Hohlzylinders mit kreisförmigem Querschnitt und erstreckt sich längs einer Äquipotentialfläche des den Hochspannungsleiter 1 umgebenden Feldes. Da der Zwischenraum zwischen dem Hochspannungsleiter 1 und der Elektrode 10 hier vollständig von der isolierenden Schicht 72 ausgefüllt ist, ist der Piezoschwinger 15 außerhalb dieses Zwischenraumes angeordnet, jedoch in der bereits im Zusammenhang mit dem Ausführungsbeispiel nach Fig. 1 beschriebenen Weise in der Nähe seines einen Endes 16 mechanisch fest eingespannt und einerseits mit dem Hochspannungsleiter 1 und andererseits mit der Elektrode 10 elektrisch leitend verbunden. Diese Ausführungsform ist insbesondere für mittlere Hochspannungen bis ca. 50 kV geeignet.

Auch bei dieser Anordnungsform ist es möglich, eine zweite Elektrode 70 vorzusehen, die dann ebenfalls unter Zwischenschaltung einer isolierenden Schicht auf den Hochspannungsleiter 1 beispielsweise aufgewickelt werden kann. Dabei kann eine konzentrische Anordnung zur Elektrode 10 gewählt werden. Alternativ ist es möglich, die Elektrode 10 und die Elektrode 70 mit einem gegenseitigen axialen Abstand anzuordnen, wie dies auch bei dem Ausführungsbeispiel gemäß Fig. 9 geschehen kann.

Eine weitere Ausführungsform ist in Fig. 11 dargestellt, bei der der Piezoschwinger 15 an seinem Ende 16 in unmittelbarem Kontakt zwischen einem an dem Hochspannungsleiter 1 direkt anliegendem Kontaktstück 75 und der Elektrode 10 mechanisch eingespannt und gleichzeitig elektrisch kontaktiert ist. Zwischen Elektrode 10 und Hochspannungsleiter 1 ist auch hier wieder eine isolierende Schicht 72 vorgesehen, die in ihrem unteren Bereich eine Ausnehmung 77 aufweist, in der das Kontaktstück 75 und das eingespannte Ende 16 des Piezoschwingers 15 untergebracht sind. In diesem Fall wird das zu modulierende Lichtbündel vorzugsweise über
eine ebenfalls am Hochspannungsleiter 1 befestigte Lichtleitfaser 76 auf die Spiegelfläche 22 eingestrahlt und
nach erfolgter Reflexion zurückgeführt.

Allen bisher beschriebenen Ausführungsbeispielen ist der
Vorteil gemeinsam, daß die Sensoreinheit nur kostengünstige Bestandteile umfaßt, die ohne weiteres in Hochspannungsanlagen an interessierenden Punkten fest installiert
werden können. Alle mit höheren Herstellungskosten behafteten Teile sind in der Meßeinheit 7 zusammengefaßt, die
von den einzelnen Sensoreinheiten 3 unabhängig ist und
von Einsatzort zu Einsatzort mitgenommen werden kann.
Da der Informationsaustausch zwischen Meßeinheit 7 und
Sensoreinheit 3 in jedem Fall nur mit Hilfe von Licht
erfolgt, ist eine absolute Berührungssicherheit gegeben.

Demgegenüber ist in Fig. 12 eine Ausführungsform der erfindungsgemäßen Meßanordnung dargestellt, bei der Meßgerät 7 und Sensoreinheit 3 durch eine Stange 90 aus
isolierendem Material miteinander verbunden sind, deren
Länge so gewählt ist, daß das eine Ende 91, in dessen
Nähe das Meßgerät 7 angeordnet ist, gefahrlos von einer
Bedienungsperson ergriffen werden kann, während gleichzeitig der aus dem anderen Ende 92 der Stange 90 herausragende Hilfsleiter 89 mit dem Hochspannungsleiter 1 in
galvanisch leitende Berührung gebracht wird.

Wie durch die gestrichelten Linie in Fig. 12 angedeutet,
ist die Sensoreinheit 3 im Inneren der hohl ausgebildeten
Stange 90 in der Nähe des vom Meßgerät 7 entfernt liegenden Endes 92 angeordnet und mit dem Meßgerät 7 durch eine
im Inneren der Stange 90 verlaufende Lichtleitfaser 94
verbunden, über die der Informationsaustausch zwischen
Meßgerät 7 und Sensoreinheit 3 in der oben beschriebenen
Weise stattfindet. Bei dem in Fig. 12 gezeigten Ausführungsbeispiel ist das freie Ende des Hilfsleiters 89 in Form
eines Hakens 95 ausgebildet, so daß die Stange 90 am
Hochspannungsleiter 1 eingehängt werden kann. Der Haken
95 ist allseits abgerundet, um das Auftreten von Sprühentladungen zu verhindern.

In Fig. 13 ist das obere Ende 92 einer derartigen Stange
90 in vergrößertem Maßstab und teilweise aufgeschnitten
dargestellt. Das freie Ende des Hilfsleiters 89 besitzt
hier keine Hakenform, sondern weist eine der Form des
Hochspannungsleiters 1 angepaßte rinnenförmige Vertiefung
97 auf, die ein Andrücken des Hilfsleiters 89 an den
Hochspannungsleiter 1 in einer genau definierten Lage
erleichtert. Auch hier weist der ansonsten als kreiszylindrischer Stab ausgebildete Hilfsleiter 89 keinerlei
scharfe Kanten auf.

Abgesehen von der unterschiedlichen Ausbildung des freien
Endes des Hilfsleiters 89 besitzen die Meßanordnungen
der in den Fig. 12 und 13 gezeigten Ausführungsbeispiele
einen identischen Aufbau.

Wie man insbesondere der Fig. 13 entnimmt, wird dadurch,
daß der Hilfsleiter 89 mit dem Hochspannungsleiter 1
in galvanisch leitende Berührung gebracht wird, das am
Hochspannungsleiter 1 anliegende elektrische Potential
in das Innere der Stange 90 hineingezogen. Dabei ist die
Länge des Hilfsleiters 89 so gewählt, daß sich um sein
unteres, halbkugelig ausgebildetes Ende 98 herum ein
eindeutiger, durch äußere Einflüsse ungestörter Potentialverlauf ergibt und die das untere Ende 98 des Hilfsleiters
89 umgebenden Äquipotentialflächen zumindest in unmittelbarer Umgebung der Längsachse des Hilfsleiters 89 in etwa
Kugelkalottenform besitzen. Zumindest sind diese Äquipotentialflächen in diesem Bereich so glatt ausgebildet,
daß eine Elektrode 10 in ihrer Form dem Verlauf dieser Äquipotentialflächen ohne weiteres angepaßt werden kann. Auch hier ist die Elektrode 10 über eine Isolationsschicht 72 unmittelbar am Hilfsleiter 89 selbst so befestigt, daß sie im Hochspannungsfeld eine genau definierte Lage einnimmt, so daß zwischen der Elektrode 10 und dem Hilfsleiter 89 eine Spannung abfällt, die der Hochspannung proportional ist.

Der auch hier als stäbchenförmiger piezoelektrischer Schwinger ausgebildete Sensor 15 ist, wie bei den anderen Ausführungsformen in der Nähe seines einen Endes 16 mechanisch eingespannt und über die Leitung 19 mit der Elektrode 10 sowie über die Leitung 18 und die Manschette 20 mit dem Hilfsleiter 89 jeweils galvanisch verbunden. Dem freien Ende 21 des Sensors 15, das eine Spiegelschicht 22 trägt, liegt, ähnlich wie in Fig. 11 das freie Ende der Lichtleitfaser 94 gegenüber, mit deren Hilfe das vom Meßgerät 7 ausgestrahlte Meßlicht auf die Spiegelschicht 22 gelenkt und das von der Spiegelschicht 22 reflektierte Licht wieder zum Meßgerät 7 zurückgeführt werden kann.

In Fig. 14 ist in schematischer Weise der elektrische Schaltungsplan einer Sensoreinheit 3 wiedergegeben, die neben dem in den Fig. 1 und 10 gezeigten Schwingsystem eine Nullpunkts-Schaltungsanordnung 100 umfaßt, mit deren Hilfe der Sensor 15 dazu veranlaßt werden kann, unabhängig von der am Hochspannungsleiter 1 anliegenden Spannung Signale abzugeben, aus denen sich seine Nullpunktslage ableiten läßt, die dem spannungsfreien Zustand des Hochspannungsleiters 1 entspricht.

Zu diesem Zweck ist parallel zum Sensor 15, d.h. zwischen dem Hochspannungsleiter 1 und der sich längs einer Äquipotentialfläche erstreckenden Elektrode 10 eine steuerbare Schalteranordnung vorgesehen, die aus zwei miteinander in Reihe liegenden Halbleiterschaltern 103, 104 und einem Strombegrenzungswiderstand 106 besteht. Jeder der beiden Halbleiterschalter 103, 104 besitzt eine Diodencharakteristik; d.h., daß er in Durchlaßrichtung immer geschlossen ist und nur in Sperrichtung in Abhängigkeit von dem Steuersignal an seinem Steuereingang entweder geöffnet oder geschlossen sein kann. Die beiden Halbleiterschalter 103, 104 sind so angeordnet, daß ihre Durchlaßrichtungen einander entgegengesetzt sind, wie dies durch die beiden Pfeile neben den Halbleiterschaltern angedeutet ist. Somit kann im Ruhezustand, d.h., wenn beide Halbleiterschalter 103, 104 geöffnet sind, zwischen dem Hochspannungsleiter 1 und der Elektrode 10 über diesen Pfad kein Strom fließen. Eine zwischen dem Hochspannungsleiter 1 und der Elektrode 10 vorhandene Spannung liegt voll am Sensor 15 an und beeinflußt dessen Auslenkung aus der Ruhelage.

Die beiden Steuereingänge der Halbleiterschalter 103, 104 sind durch eine Leitung 105 miteinander verbunden, so daß die beiden Halbleiterschalter 103, 104 immer gemeinsam geschlossen bzw. geöffnet werden. Ersteres geschieht dadurch, daß zwischen der Leitung 105 und einer Leitung 107, die die Strompfade der beiden Halbleiterschalter 103, 104 miteinander verbindet, eine von Null verschiedene Spannung angelegt wird. Ist dagegen zwischen den beiden Leitungen 105 und 107 keine Spannung vorhanden, so sind beide Halbleiterschalter 103, 104 geöffnet. Durch diese Anordnung ist es trotz

der Diodencharakteristik der Halbleiterschalter 103,
104 möglich, Gleichspannungen zwischen dem Hochspannungsleiter 1 und der Elektrode 10 unabhängig
von ihrer Polung gezielt am Sensor 15 abfallen zu
lassen bzw. kurzzuschließen. Da die vom Hochspannungsleiter 1 und der Elektrode 10 gebildete Spannungsquelle sehr hochohmig ist, fließt bei einem solchen
Kurzschluß nur ein kleiner Strom durch die steuerbaren
Halbleiterschalter 103 und 104, der überdies durch
den Widerstand 106 auf einen unkritischen Wert begrenzt
wird.

Werden die beiden Halbleiterschalter 103, 104 durch
Anlegen einer entsprechenden Spannung zwischen den
Leitungen 105 und 106 geschlossen, so bricht also
eine zwischen dem Hochspannungsleiter 1 und der Elektrode 10 vorhandene Gleich- oder Wechselspannung zusammen und der Sensor 15 geht in seine Null-Lage über.
Dies ist besonders dann von Bedeutung, wenn mit Hilfe
des Sensors 15 das Vorhandensein einer Gleich-Hochspannung zwischen dem Hochspannungsleiter 1 und der
Elektrode 10 festgestellt werden soll. Eine solche
Gleichspannung lenkt den Sensor 15 zwar ebenfalls
aus seiner Null-Lage aus, was zu einer Veränderung beispielsweise der Helligkeit eines vom Meßgerät 7 her
auf die Spiegelfläche 22 des Sensors 15 eingestrahlten
und von dieser Spiegelfläche 22 zum Meßgerät 7 reflektierten Lichtbündels führt. Als Maß für die Größe
dieser Gleichspannung kann diese Änderung aber nur dann
verwendet werden, wenn die Nullpunktslage des Sensors
15 und die bei dieser Nullpunktslage am Meßgerät 7 vorhandene Helligkeit des reflektierten Lichtbündels bekannt sind.

Die Messung einer solchen Gleichspannung ist nicht
nur dann von Bedeutung, wenn der Hochspannungsleiter 1
immer eine Gleich-Hochspannung führt, sondern auch dann,
wenn am Hochspannungsleiter 1 normalerweise eine
Wechselspannung abfällt. Selbst bei Abschaltung dieser
Wechselspannung können nämlich beispielsweise bei
einer Freileitung erhebliche Gleichspannungen im Hochspannungsleiter 1 induziert werden, deren Vorhandensein
festgestellt werden muß, da sie eine Berührung des
Hochspannungsleiters außerordentlich gefährlich machen.

Den in Fig. 14 dargestellten steuerbaren Halbleiterschaltern 103, 104 sind als Steuerschaltung eine Photodiode 108, ein Kondensator 109 und ein Widerstand 110
zugeordnet. Dabei sind der Kondensator 109 und der
Widerstand 110 miteinander in Reihe geschaltet, und
die so gebildete Serienschaltung liegt parallel zur
Photodiode 108. Die beiden Enden des Widerstandes 110
sind mit den Leitungen 105 bzw. 107 elektrisch leitend verbunden, so daß die am Widerstand 110 abfallende Spannung als Steuersignal für die beiden Halbleiterschalter 103, 104 dient. Über einen Spiegel 111
kann auf die Photodiode 108 ein Lichtbündel gelenkt
werden, das der Sensoreinheit 3 vom Meßgerät 7 her
unabhängig von dem Lichtbündel zugeführt wird, das
als Meßlichtbündel der Spiegelschicht 22 des Sensors
15 bzw. als Anregungssignal der Photodiode 45 zugeführt wird.

Die in Fig. 14 dargestellte Nullpunkts-Schaltungsanordnung 100 besitzt den großen Vorteil, daß sie keine
eigene Strom- bzw. Spannungsversorgung benötigt, da
sie die zu ihrem Arbeiten erforderliche Energie aus
dem Lichtbündel gewinnt, das auf die photovoltaisch arbeitende Photozelle 108 eingestrahlt wird. Somit
kann die Nullpunkts-Schaltungsanordnung 100 unabhängig davon arbeiten, ob am Hochspannungsleiter 1
eine Spannung anliegt oder nicht.

Dies geschieht in folgender Weise: Fällt auf die
Photodiode 108 kein Licht, so ist der Kondensator 109
ungeladen und es fließt kein Strom durch den Widerstand 110, so daß zwischen den Leitungen 105 und 107
keine Spannung vorhanden ist. Die Halbleiterschalter
103, 104 sind also geöffnet und der Sensor 15 kann
ungehindert auf eine Spannung zwischen dem Hochspannungsleiter 1 und der Elektrode 10 reagieren.

Wird dagegen ein Gleichlichtbündel auf die Photodiode
108 gerichtet, so erzeugt sie einen Photostrom, durch
den der Kondensator 109 über den Widerstand 110 geladen wird. Der Strom, der während des Ladevorgangs
durch den Widerstand 110 fließt, erzeugt am Widerstand 110 einen Spannungsabfall, der ausreicht, um
die beiden Halbleiterschalter 103, 104 zu schließen.
Dadurch bricht eine zwischen dem Hochspannungsleiter
1 und der Elektrode 10 vorhandene Spannung zusammen
und der Sensor 15 geht in seine Null-Lage über. Allerdings bleibt dieser Zustand auch bei fortdauernder
Gleichlichtbestrahlung der Photodiode 108 nur solange
erhalten, bis der Kondensator 109 völlig geladen ist.
Dann fließt kein Ladestrom mehr und am Widerstand 110
fällt auch keine Spannung mehr ab. Die Schalter 103,
104 werden also nach einer gewissen Zeit $\tau_1$ wieder
geöffnet, obwohl weiterhin Gleichlicht auf die Photodiode 108 fällt. Wird das Gleichlicht wieder abgeschaltet, so entlädt sich der Kondensator über den
Widerstand 110. Die dabei am Widerstand 110 abfallende Spannung hat jedoch ein Vorzeichen, das dem Vorzeichen der Spannung beim Ladevorgang entgegengesetzt ist, so daß die Schalter 103, 104 geöffnet bleiben.

Umfaßt eine Sensoreinheit 3, wie dies in Fig. 14 dargestellt ist, sowohl ein Resonanzschwingsystem 15, 44, 45, 46, das durch ein Anregungssignal zu Resonanzschwingungen anstoßbar ist, als auch eine Nullpunkts-Schaltungsanordnung 100, so kann damit nicht nur das Vorhandensein einer Wechsel- oder Gleichspannung zwischen dem Hochspannungsleiter 1 und der Elektrode 10 festgestellt werden, sondern es kann auch die Funktionsfähigkeit sowohl des Sensors 15 als auch des Resonanzsystems als auch der Nullpunkts-Schaltungsanordnung überprüft werden.

Die Kontrolle der Funktionsfähigkeit des Sensors und des Resonanzsystems durch Einstrahlung eines mit der Resonanzfrequenz modulierten Lichtbündels auf die Photodiode 45 wurde bereits beschrieben. Im folgenden soll die Überprüfung der Funktionsfähigkeit der Nullpunkts-Schaltungsanordnung erläutert werden. Diese Überprüfung ist aus folgendem Grund erforderlich: Wird auf die Spiegelfläche 22 des Sensors 15 über den Spiegel 28 ein Gleichlichtbündel gerichtet und kommt kein moduliertes Licht zurück, so bedeutet dies (Funktionsfähigkeit des Sensors 15 vorausgesetzt) nur, daß zwischen dem Hochspannungsleiter 1 und der Elektrode 10 keine Wechselspannung vorhanden ist. Eine allenfalls vorhandene Gleichspannung kann nur dadurch erkannt werden, daß der Sensor 15 beim Schließen der Halbleiterschalter 103, 104 aus einer ausgelenkten Lage, die durch die Gleichspannung hervorgerufen wird, in seine Null-Lage übergeht. Dies kann dadurch erkannt werden, daß sich die Helligkeit des über den Spiegel 28 eingestrahlten und reflektierten Meßlichtbündels vorübergehend ändert, wenn auf die Photodiode 108 ein Gleichlichtbündel gerichtet wird. Tritt eine solche Helligkeitsänderung des reflektierten Meßlichtbündels aber
nicht auf, so kann dies entweder auf dem Nichtvorhandensein einer Gleichspannung oder auf einem Defekt
der Nullpunkts-Schaltungsanordnung beruhen. Um zwischen diesen beiden Fällen unterscheiden zu können,
wird vom Meßgerät 7 her zunächst ein Gleichlichtbündel über den Spiegel 111 auf die Photodiode 108
gerichtet, wodurch die Schalter 103, 104 für die Zeitspanne $\tau_1$ geschlossen werden. Sendet das Meßgerät 7
während dieser Zeitspanne $\tau_1$ ein mit Resonanzfrequenz
moduliertes Lichtbündel auf die Photodiode 45 und die
Spiegelfläche 22 des Sensors 15, so kann der Sensor
15 nicht zu Resonanzschwingungen angeregt werden,
da er über die Schalter 103, 104 kurzgeschlossen ist.
Wird das modulierte Lichtbündel während der Zeit
$\tau_1$ auf Gleichlicht umgeschaltet, so darf somit
in dem von der Spiegelfläche 22 reflektierten Licht
kein Nachschwingen des Sensors 15 erkennbar sein, wenn
die Nullpunkts-Schaltungsanordnung funktionsfähig ist.
Tritt ein solches Nachschwingen jedoch auf, so bedeutet dies, daß entweder die Steuerschaltung 108, 109,
110 oder die steuerbaren Schalter 103, 104 defekt
sind und keine gesicherte Aussage über das Vorhandensein oder Nichtvorhandensein einer Gleichspannung zwischen Hochspannungsleiter 1 und Eleketrode 10 möglich
ist. Gleiches gilt auch, wenn zum Überprüfen des Sensors 15 ein mit Resonanzfrequenz moduliertes Lichtbündel auf die Photodiode 45 gerichtet wird und beim
Umschalten dieses Lichtbündels auf Gleichlicht kein
Nachschwingen des Sensors 15 feststellbar ist, obwohl auf die zweite Photodiode 108 kein Gleichlichtbündel
gerichtet ist, die Schalter 103, 104 also geöffnet
sein müßten.

In Fig. 15 ist eine etwas andere Nullpunkts-Schaltungsanordnung dargestellt, die zwei zweipolige Umschalter 113, 114 umfaßt, von denen der eine in der
Leitung 18 und der andere in der Leitung 19 mit dem
Sensor 15 so in Reihe geschaltet ist, daß in dem in
Fig. 15 wiedergegebenen Ruhezustand der Anschluß 15a
des Sensors 15 mit dem Hochspannungsleiter 1 und der
Anschluß 15b mit der Elektrode 10 verbunden ist. Im
umgeschalteten Zustand ist dagegen der Anschluß 15a
mit der Elektrode 10 und der Anschluß 15b mit dem
Hochspannungsleiter 1 verbunden. Liegt also zwischen
dem Hochspannungsleiter 1 und der Elektrode 10 eine
Gleichspannung an, die den Sensor 15 nach einer Seite hin aus seiner Null-Lage auslenkt, so wird durch
Betätigen der Umschalter 113, 114 der Sensor 15 bezüglich dieser Gleichspannung umgepolt, was zu einer
entsprechenden Auslenkung in die andere Richtung führt.

Die beiden Umschalter 113, 114 werden von dem Q-Ausgang
bzw. dem $\overline{Q}$-Ausgang eines Monoflops 117 über jeweils
ein eigens Verzögerungsglied 115, 116 angesteuert.
Der Trigger- oder Takteingang des Monoflops 117 ist
über eine Leitung mit der Verbindungsleitung zwischen
der Photodiode 45 und deren Lastwiderstand 44 verbunden, was in Fig. 15 nur symbolisch angedeutet ist.
Die beiden Verzögerungsglieder 115, 116 besitzen eine
unterschiedliche Verzögerungszeit. Weist beispielsweise das Verzögerungsglied 115 eine Verzögerungszeit
$\tau_2$ auf, so besitzt das Verzögerungsglied 116 eine
etwas größere Verzögerungszeit, die beispielsweise
gleich $\tau_2 + \delta$ ist.

0165489

Die Funktion dieser Nullpunkts-Schaltungsanordnung
wird im folgenden unter Bezugnahme auf das in Fig. 16
wiedergegebene Signaldiagramm erläutert.

Dabei ist zunächst angenommen, daß sich die beiden
Umschalter 113, 114 in der in Fig. 15 dargestellten
Lage befinden und daß ganz links zur Zeit $t_0$ auf den
Sensor 15 ein Gleichlichtsignal eingestrahlt wird,
dessen Helligkeit in der obersten Zeile von Fig. 16
wiedergegeben ist. Liegt zwischen dem Hochspannungsleiter 1 und der Elektrode 10 eine Gleichspannung an,
so wird der Sensor 15 hierdurch aus seiner Null-
Lage ausgelenkt und das zum Meßgerät 7 reflektierte
Licht besitzt eine Helligkeit, die von der Helligkeit,
die der  Null-Lage    entspricht, verschieden ist,
wie dies in der untersten Zeile von Fig. 16 durch die
Abweichung $\Delta$ symbolisiert ist. Die Größe dieser Abweichung ist zunächst nicht bekannt. Um diese Größe
festzustellen und gleichzeitig die Funktionstüchtigkeit der gesamten in Fig. 15 dargestellten Schaltungsanordnung zu überprüfen, geht das Meßgerät 7 zum Zeitpunkt $t_1$ dazu über, anstelle des Dauerlichtsignals
ein Wechsellichtsignal abzugeben. Die Frequenz dieses Wechsellichtsignals ist gleich der Resonanzfrequenz des Schwingsystems, das von der Photodiode 45,
dem Widerstand 44, dem Kondensator 46, dem Hochspannungsleiter 1, der Leitung 18, dem Sensor 15, der
Leitung 19 und der Elektrode 10 gebildet wird. Aufgrund dieses Anregungssignals, das in Fig. 16 in
der obersten Zeile wiedergegeben ist, wird der Sensor 15 zu einer Resonanzschwingung veranlaßt, die
die Helligkeit des zum Meßgerät 7 zurückgesandten
Lichtbündels zusätzlich moduliert; dies ist in der
untersten Zeile von Fig. 16 dargestellt. Da dieser Modulationseffekt unter Umständen nicht ohne weiteres von der Modulation unterschieden werden kann,
die dem vom Meßgerät 7 ausgesandten Lichtbündel aufgeprägt ist, bleibt er zunächst unberücksichtigt.

Da das Schwingungssignal des Resonanzsystems auch
dem Triggereingang des nicht nachtriggerbaren Monoflops 117 zugeführt wird, schaltet der zunächst auf
logisch Null liegende Q-Ausgang dieses Monoflops zum
Zeitpunkt $t_1$ auf logisch Eins und der $\overline{Q}$-Ausgang auf
logisch Null, wie dies in der zweiten und dritten
Zeile von oben in Fig. 16 wiedergegeben ist. Dieser
Schaltvorgang wird jedoch durch das Verzögerungsglied
115 um die Zeit $\tau_2$ und durch das Verzögerungsglied
116 um die Zeit $\tau_2 + \delta$ verzögert, so daß am Ausgang
des Verzögerungsgliedes 115 zunächst eine logische
Null und am Ausgang des Verzögerungsgliedes 116 zunächst eine logische Eins erhalten bleibt, wie dies
die vierte und fünfte Zeile von oben in Fig. 16 zeigt.
Dementsprechend bleiben die Schalter 113, 114 zunächst
in der in Fig. 15 gezeigten Stellung und die gesamte
Anordnung kann ungestört schwingen.

Zum Zeitpunkt $t_2$, d.h. vor Ablauf der Zeit $t_2$ schaltet das Meßgerät 7 wieder auf Dauerlicht um, so daß
das Schwingsystem kein Anregungssignal mehr erhält.
Wegen seiner Trägheit schwingt das Schwingsystem jedoch mit abnehmender Amplitude noch etwas nach, bis
der Sensor 15 im Zeitpunkt $t_3$ wieder in die Lage übergeht, die ihm durch die Gleichspannung zwischen dem
Hochspannungsleiter 1 und der Elektrode 10 aufgezwungen wird. Der zwischen den Zeitpunkten $t_2$ und $t_3$
auftretende Nachschwingvorgang führt zu einer Helligkeitsmodulation des von der Spiegelfläche 22 zum Meßgerät reflektierten Lichts und kann dort als eindeutiges Kennzeichen für die Funktionstüchtigkeit des
Sensors 15 und des gesamten Schwingsystems ausgewertet werden.

Nach Verstreichen der Verzögerungszeit $\tau_2$, d.h.
zum Zeitpunkt $t_4$, erscheint die vom Q-Ausgang des
Monoflops 117 abgegebene logische Eins auch am Ausgang des Verzögerungsgliedes 115; wegen der größeren
Verzögerungszeit $\tau_2 + \delta$ des Verzögerungsgliedes
116 bleibt dagegen die logische Eins am Steuereingang
des Umschalters 114 zunächst noch erhalten. Somit
wird zunächst nur der Umschalter 113 betätigt und in
die in Fig. 15 mit einer gestrichelten Linie dargestellte Lage gebracht, während der Umschalter 114
in seiner in Fig. 15 mit einer durchgezogenen Linie
wiedergegebenen Ruhelage bleibt. Dadurch wird der
Sensor 15 einerseits vom Hochspannungsleiter 1 galvanisch getrennt und andererseits kurzgeschlossen.
Dadurch bricht die am Sensor 15 abfallende Gleichspannung zusammen und der Sensor geht in seine Null-
Lage über, die einem spannungsfreien Zustand entspricht. Dies führt zu einem Helligkeitssprung 121
(siehe Fig. 16, unterste Zeile) in dem zum Meßgerät 7 reflektierten Lichtbündel. Die Höhe dieses
Helligkeitssprunges stellt ein Maß für die am Hochspannungsleiter 1 anliegende Gleichspannung dar.

Zur Zeit $t_4 + \delta$ geht das Ausgangssignal des Verzögerungsgliedes 116 von einer logischen Eins zu
einer logischen Null über, so daß dann auch der
andere Umschalter 114 in die in Fig. 15 mit einer
gestrichelten Linie dargestellte Lage übergeht.
Dadurch liegt der Sensor 15 mit umgekehrter Polung
an der Gleichspannung, die zwischen dem Hochspannungs-

leiter 1 und der Elektrode 10 abfällt. Es erfolgt jetzt ein Ausschlag des Sensors in der dem vorherigen Ausschlag entgegengesetzten Richtung, was zu einem Helligkeitssprung 122 (siehe Fig. 16, unterste Zeile) in dem zum Meßgerät reflektierten Lichtbündel führt.

Treten zu dem Zeitpunkt $t_4$ und $t_4 + \delta$ keine Helligkeitssprünge auf, so kann dies entweder bedeuten, daß am Hochspannungsleiter 1 keine Gleichspannung anliegt oder daß die Umschalter 113, 114 bzw. die Schaltungseinheiten 117, 115, 116 nicht funktionstüchtig sind. Um diese beiden Fälle voneinander unterscheiden zu können, sendet das Meßgerät 7 zum Zeitpunkt $t_5$, d.h. zwischen den beiden Zeitpunkten $t_4$ und $t_4 - \delta$ nochmals ein kurzes Wechsellichtsignal 125 aus. Die Helligkeitsmodulation dieses Wechsellichtsignals muß dann, wenn die Nullpunkts-Schaltungsanordnung funktionstüchtig und somit der Sensor 15 in diesem Zeitraum kurzgeschlossen ist, von der Spiegelfläche 22 ohne zusätzliche Modulation zum Meßgerät reflektiert werden. Insbesondere darf es nach dem Zeitpunkt $t_6$, in dem das Meßgerät wieder auf Dauerlicht umschaltet, zu keinerlei Nachschwingvorgängen kommen, wie sie zwischen den Zeitpunkten $t_2$ und $t_3$ aufgetreten sind. Tritt ein solches Nachschwingen nach dem Zeitpunkt $t_6$ auf, so bedeutet dies, daß die aus dem Monoflop 117, den Verzögerungsgliedern 115, 116 und den Schaltern 113, 114 bestehende Nullpunkts-Schaltungsanordnung defekt ist, und daß aus dem Fehlen der Helligkeitssprünge 121, 122 nicht auf die Spannungsfreiheit des Hochspannungsleiters 1 geschlossen werden darf.

Zum Zeitpunkt $t_7$ kippt das Monoflop 117 wieder in seinen Ausgangszustand zurück, so daß an seinem Q-Ausgang
die logische Eins und an seinem $\overline{Q}$-Ausgang die logische
Null verschwindet. Mit den Verzögerungen $\tau_2'$ und
$\tau_2' + \delta'$ reagieren hierauf auch die Ausgänge der
Verzögerungsglieder 115 und 116. Hierdurch wird zum
Zeitpunkt $t_8$ der Umschalter 113 wieder in die in
Fig. 15 mit einer durchgezogenen Linie dargestellte
Stellung gebracht, während der Umschalter 114 zunächst
in der mit einer gestrichelten Linie wiedergegebenen
Lage bleibt. Dadurch ist der Sensor 15 wieder vorübergehend von der Spannung zwischen dem Hochspannungsleiter 1 und der Elektrode 10 abgetrennt und gleichzeitig
kurzgeschlossen. Wenn zwischen dem Hochspannungsleiter
1 und der Elektrode 10 eine Gleichspannung anliegt,
tritt hier also ein zum Helligkeitssprung 122 entgegengesetzter Helligkeitssprung 123 in dem zum Meßgerät 7 reflektierten Lichtbündel auf.

Zum Zeitpunkt $t_9$ erscheint dann auch am Ausgang des
Verzögerungsgliedes 116 eine logische Eins, wodurch
der Schalter 114 in seine in Fig. 15 mit einer durchgezogenen Linie wiedergegebene Ausgangslage zurückkehrt. Damit ist der Sensor 15 wieder in der ursprünglichen Polung zwischen den Hochspannungsleiter
1 und die Elektrode 10 geschaltet. Beim Anliegen einer
Gleichspannung zwischen dem Hochspannungsleiter 1 und
der Elektrode 10 tritt zum Zeitpunkt $t_9$ in der Helligkeit des zum Meßgerät 7 reflektierten Lichtbündels
ein Helligkeitssprung 124 auf, der dem Helligkeitssprung 121 entgegengesetzt ist.

Zusätzlich oder alternativ zu den in Fig. 14 gezeigten, mit dem Sensor 15 parallel geschalteten steuerbaren Schaltern 103, 104 kann in einer der beiden Leitungen 18, 19 ein mit dem Sensor 15 in Reihe liegender steuerbarer Ein/Aus-Schalter vorgesehen werden,
der dann im Gegentakt zu den Schaltern 103, 104 gesteuert wird. Dieser Schalter ist im Ruhezustand geschlossen, so daß die Spannung zwischen dem Hochspannungsleiter 1 und der Elektrode 10 ungehindert
an den Sensor 15 gelangen kann. Werden die Schalter 103, 104 geschlossen, so wird dieser Schalter
geöffnet, wodurch einerseits eine gegebenenfalls
zwischen dem Hochspannungsleiter 1 und der Elektrode
10 vorhandene Spannung zusammenbricht und andererseits
der Sensor 15 spanungsfrei gemacht wird.

Patentansprüche

1. Anordnung zum Messen der elektrischen Spannungsparameter eines Hochspannungsleiters mit einem Sensor,
der in dem den Hochspannungsleiter umgebenden elektrischen Feld angeordnet ist und in Abhängigkeit
von diesem Feld ein Lichtbündel verändert, das von
einer vom Hochspannungsleiter entfernt angeordneten
Lichtquelle ausgesandt, auf den Sensor projiziert
und zu einem vom Hochspannungsleiter entfernt angeordneten photoelektrischen Empfänger geleitet wird,
dessen Ausgangssignale ausgewertet werden, dadurch
g e k e n n z e i c h n e t , daß eine den Hochspannungsleiter (1) direkt berührende Sensoreinheit (3) wenigstens eine vom Hochspannungsleiter (1) isolierte, nichtgeerdete Elektrode (10) umfaßt, die in einem fest vorgegebenen Abstand vom Hochspannungsleiter (1) angeordnet ist und sich im wesentlichen längs einer Äquipotentialfläche des den Hochspannungsleiter (1) umgebenden Feldes erstreckt, und daß der Sensor (15) einerseits mit der Elektrode (10) und andererseits mit einer Referenzelektrode elektrisch leitend verbunden ist, die von der Elektrode (10) isoliert ist und sich auf einem fest vorgegebenen Potential befindet, das von dem der Elektrode (10) verschieden ist.

2. Anordnung nach Anspruch 1, dadurch g e - k e n n z e i c h n e t , daß der Abstand zwischen der Elektrode (10) und der Referenzelektrode so gewählt ist, daß zwischen ihnen eine Maximalspannung abgreifbar ist, die in einem Bereich von 20 V bis 2000 V liegt, wenn der Hochspannungsleiter (1) Nennspannung führt.

3. Anordnung nach einem der vorhergehenden Ansprüche, dadurch g e k e n n z e i c h n e t , daß die Referenzelektrode der Hochspannungsleiter (1) selbst ist.

4. Anordnung nach einem der Ansprüche 1 oder 2, dadurch g e k e n n z e i c h n e t , daß die Referenzelektrode eine zweite, nichtgeerdete, zur Sensoreinheit (3) gehörende Elektrode (70) ist, die in einem vom Abstand der ersten Elektrode (10) verschiedenen, fest vorgegebenen Abstand vom Hochspannungsleiter (1) und von diesem isoliert so angeordnet ist, daß sie sich im wesentlichen längs einer Äquipotentialfläche erstreckt.

5. Anordnung nach Anspruch 3 oder 4, dadurch g e - k e n n z e i c h n e t , daß jede Elektrode (10; 10, 70) in etwa die Form eines Kreiszylinders besitzt, der den Hochspannungsleiter (1) konzentrisch umgibt.

6. Anordnung nach Anspruch 4 und 5, dadurch g e - k e n n z e i c h n e t , daß die eine (10) der beiden Elektroden (10, 70) die andere (70) konzentrisch umgibt.

7. Anordnung nach einem der Ansprüche 1 oder 2, dadurch g e k e n n z e i c h n e t , daß die Referenzelektrode ein mit dem Hochspannungsleiter (1) galvanisch verbindbarer Hilfsleiter (87) ist.

8. Anordnung nach einem der Ansprüche 3 bis 7, dadurch g e k e n n z e i c h n e t , daß die Elektroden (10; 10, 70) vom Hochspannungsleiter (1) oder vom Hilfsleiter (87) und/oder voneinander durch Isolatoren im Abstand gehalten sind und daß der Sensor (15) in dem Zwischenraum zwischen der einen Elektrode (10) und dem Hochspannungsleiter (1) oder dem Hilfsleiter (87) bzw. in dem Zwischenraum zwischen den Elektroden (10, 70) angeordnet ist.

9. Anordnung nach einem der Ansprüche 3 bis 7, dadurch g e k e n n z e i c h n e t , daß die Elektroden (10; 10, 70) vom Hochspannungsleiter (1) oder vom Hilfsleiter (87,89) und voneinander jeweils durch eine Schicht aus isolierendem Material getrennt sind, die als mechanischer Träger dient und deren Dicke den Abstand zwischen den Elektroden (10; 10, 70) und dem Hochspannungsleiter (1) bzw. dem Hilfsleiter (87, 89) bzw. den Abstand der Elektroden (10, 70) voneinander bestimmt.

10. Anordnung nach einem der Ansprüche 1 bis 9, dadurch g e k e n n z e i c h n e t , daß der Sensor (15) ein mechanischer Schwinger in Form eines länglichen Stäbchens ist, das in der Nähe seines einen Endes (16) mechanisch eingespannt ist und an der Stirnseite seines freien Endes (21) eine Spiegelschicht (22) aufweist, auf die das Lichtbündel (32) der Lichtquelle (31) projiziert wird.

11. Anordnung zum Messen der elektrischen Spannungsparameter eines Hochspannungsleiters mit einem Sensor, der in dem den Hochspannungsleiter umgebenden elektrischen Feld angeordnet ist und in Abhängigkeit von diesem Feld ein Lichtbündel verändert, das von einer vom Hochspannungsleiter entfernt angeordneten Lichtquelle ausgesandt, auf den Sensor projiziert und zu einem vom Hochspannungsleiter entfernt angeordneten photoelektrischen Empfänger geleitet wird, dessen Ausgangssignale ausgewertet werden, dadurch g e k e n n z e i c h n e t , daß der Sensor (15) ein mechanischer Schwinger in Form eines länglichen Stäbchens ist, das in der Nähe seines einen Endes (16) mechanisch eingespannt ist und an der Stirnseite seines freien Endes (21) eine Spiegelschicht (22) aufweist, auf die das Lichtbündel (32) der Lichtquelle (31) projiziert wird.

12. Anordnung nach Anspruch 10 oder 11, dadurch g e - k e n n z e i c h n e t , daß der mechanische Schwinger (15) aus einem piezoelektrischen Material besteht.

13. Anordnung nach einem der Ansprüche 10 bis 12, dadurch g e k e n n z e i c h n e t , daß die Spiegelschicht (22) auf die Stirnfläche des freien Endes (21) des Schwingers (15) aufgedampft ist.

14. Anordnung nach einem der vorhergehenden Ansprüche,
    dadurch g e k e n n z e i c h n è t , daß ein
    Teil des von der Projektionsvorrichtung (28,29,34)
    zum Sensor (15) projizierten Lichtbündels (32) auf
    einen ruhenden Spiegel (37) führbar ist, der in der
    Nähe des Sensors (15) angeordnet ist und das Licht
    über die Projektionsvorrichtung zum photoelektrischen
    Empfänger (40) reflektiert.

15. Anordnung nach einem der Ansprüche 10 bis 14,
    dadurch g e k e n n z e i c h n è t , daß vor
    dem freien Ende (21) des mechanischen Schwingers (15)
    eine feststehende Blende (25) angeordnet ist, deren
    der Lichtquelle (31) zugewandte Seite den ruhenden
    Spiegel (37) trägt, und die durch die Projektionsvorrichtung (28,29,34) auf den photoelektrischen
    Empfänger (40) abgebildet wird.

16. Anordnung nach einem der Ansprüche 10 bis 14,
    dadurch g e k e n n z e i c h n e t , daß die
    Projektionsvorrichtung eine Lichtleitfaser umfaßt,
    deren eines Stirnende so angeordnet ist, daß es dem
    freien Ende des mechanischen Schwingers in dessen
    Ruhestellung unmittelbar gegenüberliegt, und deren
    anderes Stirnende auf den photoelektrischen Empfänger
    abgebildet wird.

17. Anordnung nach Anspruch 16, dadurch g e -
    k e n n z e i c h n e t , daß die Abbildung des
    anderen Stirnendes der Lichtleitfaser auf den
    photoelektrischen Empfänger mit Hilfe einer weiteren Lichtleitfaser erfolgt, die mit der ersten
    Lichtleitfaser durch einen steckbaren Verbinder
    optisch koppelbar ist.

18. Anordnung nach einem der Ansprüche 1 bis 17, dadurch
    g e k e n n z e i c h n e t , daß der Sensor (15)
    durch ein von der im Hochspannungsleiter (1) übertragenen Energie unabhängiges Anregungssignal zu
    einer Veränderung der Eigenschaften des Lichtbündels
    (32) anregbar ist.

19. Anordnung zum Messen der elektrischen Spannungsparameter eines Hochspannungsleiters mit einem Sensor,
    der in dem den Hochspannungsleiter umgebenden elektrischen Feld angeordnet ist und in Abhängigkeit
    von diesem Feld ein Lichtbündel verändert, das von
    einer vom Hochspannungsleiter entfernt angeordneten Lichtquelle ausgesandt, auf den Sensor projiziert und zu einem vom Hochspannungsleiter entfernt
    angeordneten photoelektrischen Empfänger geleitet
    wird, dessen Ausgangssignale ausgewertet werden,
    dadurch g e k e n n z e i c h n e t , daß der Sensor
    (15) durch ein von der im Hochspannungsleiter (1)
    übertragenen Energie unabhängiges Anregungssignal
    zu einer Veränderung des Lichtbündels (32) anregbar
    ist.

20. Anordnung nach Anspruch 18 oder 19, dadurch g e -
    k e n n z e i c h n e t , daß der Sensor (15) Teil
    eines Schwingsystems ist, das durch das Anregungssignal zu einer Resonanzschwingung anstoßbar ist.

21. Anordnung nach Anspruch 20, dadurch g e k e n n -
    z e i c h n e t , daß das Schwingsystem eine Photodiode mit einem Schutzwiderstand (44) umfaßt, die
    miteinander in Reihe und gemeinsam zum Sensor (15)
    parallelgeschaltet sind, und daß der Photodiode
    (45) als Anregungssignal Licht zuführbar ist, das mit
    einer Frequenz helligkeitsmoduliert ist, die in etwa
    der Resonanzfrequenz des Schwingsystems entspricht.

22. Anordnung nach einem der Ansprüche 18 bis 21, dadurch g e k e n n z e i c h n e t , daß die Amplitude und/oder das Dämpfungsverhalten der durch das
Anregungssignal angestoßenen Schwingung des Sensors
(15) zur Berücksichtigung der momentanen Temperatur
des Sensors (15) und zur Eliminierung von weiteren
Umwelteinflüssen ausgewertet wird.

23. Anordnung nach einem der vorhergehenden Ansprüche,
dadurch g e k e n n z e i c h n e t , daß das die
Lichtquelle (31), den photoelektrischen Empfänger
(40) und die Auswerte- und Anzeigevorrichtung (42)
umfassende Meßgerät (7) gegen die Sensoreinheit (3)
frei bewegbar ist.

24. Anordnung nach Anspruch 23, dadurch g e k e n n -
z e i c h n e t , daß die Sensoreinheit (3) fest am
Hochspannungsleiter montiert ist.

25. Anordnung nach Anspruch 23, dadurch g e k e n n -
z e i c h n e t , daß die Sensoreinheit (3) auf
den Hochspannungsleiter (1) aufsteckbar ist.

26. Anordnung nacheinem der vorhergehenden Ansprüche,
dadurch g e k e n n z e i c h n e t , daß die
Sensoreinheit (3) ein Gehäuse (9) aufweist, dessen
Außenwände in Art eines Hochspannungsisolators mit
vorstehenden Rippen (64, 65) und dazwischenliegenden Vertiefungen (66, 67, 68) zur Unterbindung von
Kriechströmen versehen sind.

27. Anordnung nach einem der Ansprüche 1 bis 22, dadurch
g e k e n n z e i c h n e t , daß die Sensoreinheit
(3) an einer isolierenden Stange (90) montiert ist,
an deren einem Ende (92) ein mit dem Hochspannungsleiter (1) in Berührung bringbarer Hilfsleiter (89)
angeordnet ist.

28. Anordnung nach Anspruch 27, dadurch g e k e n n -
z e i c h n e t , daß der Hilfsleiter (89) eine
muldenförmige Vertiefung (97) aufweist, mit der er
gegen den Hochspannungsleiter (1) andrückbar ist.

29. Anordnung nach Anspruch 27, dadurch g e k e n n -
z e i c h n e t , daß der Hilfsleiter (89) einen
Haken (95) aufweist, mit dem er am Hochspannungsleiter (1) einhängbar ist.

30. Anordnung nach einem der Ansprüche 27 bis 29, dadurch
g e k e n n z e i c h n e t , daß die Sensoreinheit
(3) im Inneren der Stange (90) angeordnet ist, aus
deren einem Ende (92) der Hilfsleiter (87) herausragt, und daß am anderen Ende (91) der Stange (90)
das Meßgerät (7) befestigt ist.

31. Anordnung nach einem der vorhergehenden Ansprüche,
dadurch g e k e n n z e i c h n e t , daß die Sensoreinheit (3) eine Nullpunkts-Schaltungsanordnung (100)
umfaßt, mit deren Hilfe der Sensor (15) dazu veranlaßt werden kann, Signale abzugeben, aus denen sich
seine Nullpunktslage ableiten läßt, die dem spannungsfreien Zustand des Hochspannungsleiters (1) entspricht.

32. Anordnung nach Anspruch 31, dadurch g e k e n n -
z e i c h n e t , daß die Nullpunkts-Schaltungsanordnung (100) eine steuerbare Schalteranordnung, mit
deren Hilfe die am Sensor (15) anliegende Spannung
veränderbar ist, und eine Steuerschaltung umfaßt, die
durch ein Befehlssignal zur Betätigung der Schalteranordnung triggerbar ist.

33. Anordnung nach Anspruch 32, dadurch g e k e n n -
z e i c h n e t , daß die Schalteranordnung wenigstens einen steuerbaren Ein/Aus-Schalter (103,104) umfaßt, der im
Ruhezustand geöffnet ist und der im geschlossenen
Zustand die am Sensor (15) abfallende Spannung kurzschließt.

34. Anordnung nach Anspruch 31 oder 32, dadurch g e -
k e n n z e i c h n e t , daß die Schalteranordnung
wenigstens einen steuerbaren Ein/Aus-Schalter umfaßt,
der im Ruhezustand geschlossen ist, und der im geöffneten Zustand eine der beiden galvanischen Verbindungen (19, 18) zwischen dem Sensor (15) und dem
Hilfsleiter (87, 89) bzw. der Referenzelektrode (70)
bzw. dem Hochspannungsleiter (1) oder zwischen dem
Sensor (15) und der sich längs einer Äquipotentialfläche erstreckenden Elektrode (10) unterbricht.

35. Anordnung nach Anspruch 32, dadurch g e k e n n -
z e i c h n e t , daß die Schalteranordnung zwei
steuerbare Umschalter (114, 113) umfaßt, mit deren
Hilfe die galvanischen Verbindungen (19, 18) des
Sensors (15) zur Referenzelektrode (70) bzw. zum Hilfsleiter (87, 89) bzw. zum Hochspannungsleiter (1) einerseits und zu der sich längs einer Äquipotentialfläche
erstreckenden Elektrode (10) andererseits gegeneinander
vertauschbar sind.

36. Anordnung nach einem der Ansprüche 32 bis 35, dadurch
g e k e n n z e i c h n e t , daß die Steuerschaltung
ein durch das Befehlssignal triggerbares Monoflop
(117) umfaßt, durch das die Schalteranordnung für
eine vorgegebene Zeit aus ihrer Ruhestellung in die
Arbeitsstellung und dann wieder zurück in die Ruhestellung bringbar ist.

37. Anordnung nach Anspruch 36 und 21, dadurch g e -
k e n n z e i c h n e t , daß als Befehlssignal zum
Triggern des Monoflops (117) ein Teil des zum Anstoßen einer Resonanzschwingung des Schwingsystems
dienenden Anregungssignals dient und daß zwischen jeden die Schalteranordnung steuernden Ausgang des
Monoflops (117) und die steuerbare Schalteranordnung
ein Verzögerungsglied (115,116) geschaltet ist.

38. Anordnung nach einem der Ansprüche 32 bis 35, dadurch g e k e n n z e i c h n e t , daß die
Steuerschaltung eine Photodiode (108) umfaßt, die
photovoltaisch arbeitet und mit einem Gleichlicht-
Befehlssignal ansteuerbar ist, daß zur Photodiode
(108) eine aus einem Kondensator (109) und einem
Widerstand (110) bestehende Serienschaltung parallelgeschaltet ist, und daß die Spannung, die beim Fließen
eines Ladestroms auf den Kondensator (109) am Widerstand (110) abfällt, als Steuersignal für die steuerbare Schalteranordnung dient.

39. Anordnung nach Anspruch 33 und 38, dadurch g e -
k e n n z e i c h n e t , daß die steuerbare Schalteranordnung aus zwei Halbleiterschaltern (103,104)
mit Diodencharakteristik besteht, die mit entgegengesetzter Polung miteinander in Reihe und zum Sensor (15) parallelgeschaltet sind.

FIG. 1

2/6

0165489

FIG. 2

FIG. 3

FIG. 4

FIG. 5

FIG. 6a

FIG. 6b

0165489

FIG. 7

FIG. 8

FIG. 9

# FIG. 10

# FIG. 11

FIG. 12

FIG. 13

FIG. 14

FIG. 15

FIG. 16

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | EP-A-0 010 221 (ASEA AB)<br><br>* Zusammenfassung; Seite 3, Zeilen 21-35; Seite 4, Zeilen 1-28; Abbildungen 1-2 * | 1-6,11 -12 | G 01 R 15/07 |
| A | | 10,16 | |
| | --- | | |
| Y | PATENTS ABSTRACTS OF JAPAN, Band 7, Nr. 238 (P-231)(1383), 22. Oktober 1983; & JP - A - 58 124 961 (MITSUBISHI DENKI K.K.) 25.07.1983<br>* Insgesamt * | 1-6,11 -12 | |
| A | --- | 24 | |
| | | | RECHERCHIERTE SACHGEBIETE (Int. Cl.4) |
| A | DE-A- 606 438 (METALLGESELLSCHAFT A.G.) * Anspruch 1; Abbildung 1 * | 27,29- 30 | G 01 R |
| | --- | | |
| A | DE-A-2 409 595 (SIEMENS A.G.) * Seite 2, Zeilen 8-28; Seite 5, ab Absatz 2; Seite 6, Zeilen 1-4; Abbildungen 1-2 * | 4-6,24 | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 03-09-1985 | KAUFFMANN J. |

Europäisches Patentamt

EUROPÄISCHER RECHERCHENBERICHT

0165489
Nummer der Anmeldung

EP 85 10 6164

Seite 2

## EINSCHLÄGIGE DOKUMENTE

| Kategorie | Kennzeichnung des Dokuments mit Angabe. soweit erforderlich. der maßgeblichen Teile | Betrifft Anspruch | KLASSIFIKATION DER ANMELDUNG (Int. Cl.4) |
|---|---|---|---|
| A | REVIEW OF SCIENTIFIC INSTRUMENTS, Band 47, Nr. 5, Mai 1976, Seiten 621-623, New York, US; C.A. BLEYS: " Floating input, optically isolated, high-voltage measurement probe" * Seite 622, Absatz: "Circuit", Abbildung 2; Seite 623, Absatz: "Calibrator", Abbildung 3 * | 32 | |

-----

RECHERCHIERTE SACHGEBIETE (Int. Cl.4)

Der vorliegende Recherchenbericht wurde für alle Patentansprüche erstellt.

| Recherchenort DEN HAAG | Abschlußdatum der Recherche 03-09-1985 | Prüfer KAUFFMANN J. |
|---|---|---|